# EUROPEAN PATENT APPLICATION

(11) **EP 4 607 574 A1**
(43) Date of publication of application: **27.08.2025**
(21) Application number: 23879885.4
(22) Date of filing: 20.10.2023
(51) Int. Cl.: H01L 21/205

(54) **SEMICONDUCTOR SUBSTRATE, TEMPLATE SUBSTRATE, AND METHOD AND DEVICE FOR PRODUCING TEMPLATE SUBSTRATE**

(30) Priority: 20.10.2022 WO PCT/JP2022/039142
(71) Applicant: Kyocera Corporation, Kyoto-shi, Kyoto 612-8501 (JP)
(72) Inventor: MASAKI, Katsuaki, Kyoto-shi, Kyoto 612-8501 (JP); KAMIKAWA, Takeshi, Kyoto-shi, Kyoto 612-8501 (JP); TAKEUCHI, Kazuma, Kyoto-shi, Kyoto 612-8501 (JP); TADA, Tatsuo, Kyoto-shi, Kyoto 612-8501 (JP)
(74) Representative: Viering, Jentschura & Partner mbB Patent- und Rechtsanwälte
(86) International application number: PCT/JP2023/037960
(87) International publication number: WO 2024/085243

(57) **Abstract**

A semiconductor substrate includes a template substrate including a first seed region and a growth suppression region, and a first semiconductor part. The first semiconductor part includes a first base located above the first seed region, and a first wing contact to the first base and located above the growth suppression region. The template substrate includes a main substrate, a metal layer located above the main substrate, and an aluminum-based nitride layer located above the metal layer and containing argon. The first semiconductor part includes a nitride semiconductor.

## Description

### TECHNICAL FIELD

The present disclosure relates to a semiconductor substrate, a template substrate, and a method and an apparatus for manufacturing the template substrate.

### BACKGROUND OF INVENTION

Patent Document 1 describes a technique in which an aluminum nitride (AlN) layer serving as a buffer layer is formed using a silicon (Si) substrate on which a selective growth mask having an opening is formed, and then a gallium nitride (GaN) layer is selectively grown. In the method described in Patent Document 1, the AlN layer and the GaN layer are formed using a metal organic chemical vapor deposition (MOCVD) method.

### CITATION LIST

### PATENT LITERATURE

Patent Document 1: JP 2008-235709 A

### SUMMARY

In an aspect of the present disclosure, a semiconductor substrate includes: a template substrate including a first seed region and a growth suppression region; and a first semiconductor part including a first base located above the first seed region, and a first wing contact to the first base and located above the growth suppression region. The template substrate includes a main substrate, a metal layer located above the main substrate, and an aluminum-based nitride layer located above the metal layer and containing argon, and the first semiconductor part includes a nitride semiconductor.

In an aspect of the present disclosure, a semiconductor substrate includes: a template substrate including a first seed region and a growth suppression region; and a first semiconductor part including a first base located above the first seed region, and a first wing contact to the first base and located above the growth suppression region. The template substrate includes a main substrate, and an aluminum-based nitride layer in which a nitrogen polar plane is bonded to the main substrate and containing argon, and the first semiconductor part includes a nitride semiconductor.

In an aspect of the present disclosure, a template substrate includes a main substrate, a metal layer located above the main substrate, and an aluminum-based nitride layer located above the metal layer and containing argon.

In an aspect of the present disclosure, a manufacturing method of a template substrate is a manufacturing method of a template substrate including a main substrate and includes the steps of: forming a metal layer above the main substrate; and forming an aluminum-based nitride layer above the metal layer by using a sputtering method.

In an aspect of the present disclosure, a manufacturing method of a template substrate is a manufacturing method of a template substrate including a main substrate and includes the steps of: forming a metal layer on a temporary substrate; forming an aluminum-based nitride layer above the metal layer by using a sputtering method; and transferring the aluminum-based nitride layer from the temporary substrate to the main substrate.

### BRIEF DESCRIPTION OF THE DRAWINGS

FIG. 1 is a plan view schematically illustrating a configuration of a semiconductor substrate in an embodiment of the present disclosure.
FIG. 2 is a cross-sectional view schematically illustrating a configuration of a semiconductor substrate in an embodiment of the present disclosure.
FIG. 3 is a flowchart illustrating an example of a manufacturing method of a semiconductor substrate in an embodiment of the present disclosure.
FIG. 4 is a cross-sectional view schematically illustrating a configuration of a semiconductor substrate in another embodiment of the present disclosure.
FIG. 5 is a flowchart illustrating an example of a manufacturing method of a semiconductor substrate in another embodiment of the present disclosure.
FIG. 6 is a block diagram illustrating an example of a manufacturing apparatus in an embodiment of the present disclosure.
FIG. 7 is a cross-sectional view schematically illustrating a configuration of a template substrate in Example 1.
FIG. 8 is a cross-sectional view illustrating a manufacturing method of the template substrate in Example 1.
FIG. 9 is a cross-sectional view schematically illustrating a configuration of a semiconductor substrate in Example 1.
FIG. 10 is a cross-sectional view illustrating an example of lateral growth of a semiconductor part.
FIG. 11 is a plan view illustrating another configuration example of the semiconductor substrate in Example 1.
FIG. 12 is a cross-sectional view illustrating another configuration example of the semiconductor substrate in Example 1.
FIG. 13 is a cross-sectional view illustrating another configuration example of the semiconductor substrate in Example 1.
FIG. 14 is a cross-sectional view illustrating another configuration example of the semiconductor substrate in Example 1.
FIG. 15 is a cross-sectional view illustrating another configuration example of the semiconductor substrate in Example 1.
FIG. 16 is a plan view illustrating another configuration example of the semiconductor substrate in Example 1.
FIG. 17 is a plan view illustrating a method of element isolation in Example 1.
FIG. 18 is a cross-sectional view illustrating the method of element isolation in Example 1.
FIG. 19 is a plan view illustrating another configuration example of the semiconductor substrate in Example 1.
FIG. 20 is a plan view schematically illustrating a configuration of a semiconductor substrate in Example 2.
FIG. 21 is a cross-sectional view schematically illustrating the configuration of the semiconductor substrate in Example 2.
FIG. 22 is a cross-sectional view illustrating an example of a manufacturing method of the semiconductor substrate in Example 2.
FIG. 23 is a cross-sectional view illustrating another configuration example of the semiconductor substrate in Example 2.
FIG. 24 is a cross-sectional view illustrating another configuration example of the semiconductor substrate in Example 2.
FIG. 25 is a cross-sectional view illustrating another configuration example of the semiconductor substrate in Example 2.
FIG. 26 is a cross-sectional view illustrating another configuration example of the semiconductor substrate in Example 2.
FIG. 27 is a cross-sectional view illustrating an example of a manufacturing method of a semiconductor substrate in Example 3.
FIG. 28 is a cross-sectional view illustrating an example of a manufacturing method of a template substrate of another configuration example in Example 3.
FIG. 29 is a cross-sectional view illustrating an example of a manufacturing method of the template substrate of another configuration example in Example 3.
FIG. 30 is a cross-sectional view illustrating an example of a manufacturing method of a semiconductor substrate in Example 4.

### DESCRIPTION OF EMBODIMENTS

An embodiment of the present disclosure will be described below with reference to the accompanying drawings. However, the following description is for better understanding of the gist of the present disclosure and does not limit the present disclosure unless otherwise specified. Shapes and dimensions (length, width, and the like) of the configurations illustrated in the drawings in the present application do not necessarily reflect actual shapes and dimensions, and are appropriately changed for clarification and simplification of the drawings.

### Semiconductor Substrate

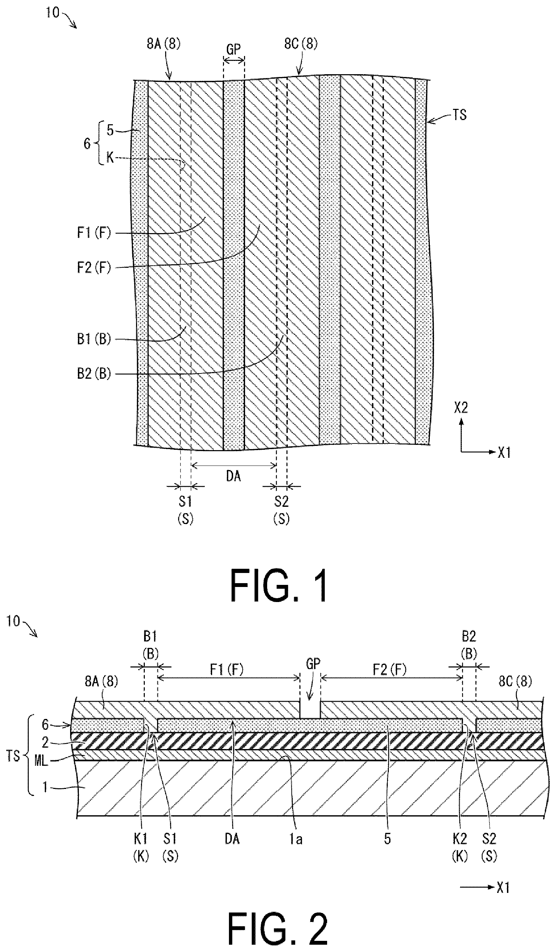

FIG. 1 is a plan view schematically illustrating a configuration of a semiconductor substrate 10 in an embodiment of the present disclosure. FIG. 2 is a cross-sectional view schematically illustrating a configuration of a semiconductor substrate 10 in an embodiment of the present disclosure. Note that, as in FIG. 1 and the like in the present disclosure, members may be hatched also in a plan view for the sake of clarity of the drawing, and the same applies to other drawings described below.

As illustrated in FIG. 1 and FIG. 2, the semiconductor substrate 10 includes a template substrate TS including a first seed region S1 and a growth suppression region DA, and a first semiconductor part 8A located above the template substrate TS. The first semiconductor part 8A includes a first base B1 located above the first seed region S1, and a first wing F1 contact to the first base B1 and located above the growth suppression region DA. The template substrate TS includes a main substrate 1, a metal layer ML located above the main substrate 1, and an aluminum-based nitride layer (Al-based nitride layer) 2 located above the metal layer ML and containing argon. The first semiconductor part 8A includes a nitride semiconductor.

In the semiconductor substrate 10 of the present embodiment, the template substrate TS may include a mask pattern 6. The mask pattern 6 includes a mask 5 configured to function as the growth suppression region DA and a first opening K1 corresponding to the first seed region S1. Specifically, a surface (upper surface) of the mask 5 may be the growth suppression region DA.

The first semiconductor part 8A may include a nitride semiconductor as a main component. The nitride semiconductor may be expressed by, for example, AlxGayInzN (0 ≤ x ≤ 1; 0 ≤ y ≤ 1; 0 ≤ z ≤ 1; x + y + z = 1). Specific examples of the nitride semiconductor include a GaN-based semiconductor, AlN, indium aluminum nitride (InAlN), and indium nitride (InN). The GaN-based semiconductor is a semiconductor containing gallium atoms (Ga) and nitrogen atoms (N). Typical examples of the GaN-based semiconductor include GaN, AlGaN, AlGaInN, and InGaN.

The first semiconductor part 8A may be a doped type (for example, an n-type including a donor) or a non-doped type. The semiconductor substrate refers to a substrate including a nitride semiconductor. The main substrate 1, the metal layer ML, and the Al-based nitride layer 2 may be collectively referred to as a base substrate.

The main substrate 1 may be a heterogeneous substrate having a lattice constant different from that of the first semiconductor part 8A, and the Al-based nitride layer 2 may be a seed layer including the first seed region S1 and may be in contact with the first base B1. The Al-based nitride layer 2 may be, for example, an AlN layer. The first semiconductor part 8A does not contain argon. To be specific, the surface (upper surface) of the Al-based nitride layer 2 may be the first seed region S1.

The first semiconductor part 8A can be formed by an epitaxial lateral overgrowth (ELO) method on the template substrate TS. In the ELO method, for example, a heterogeneous substrate having a lattice constant different from that of a nitride semiconductor is used as the main substrate 1, an inorganic compound film is used for the mask 5, and the first seed region S1 exposed in the first opening K1 can be used as a starting point of crystal growth. With this, an initial growth layer is formed on the first seed region S1, and then the first semiconductor part 8A including a nitride semiconductor can be laterally grown on the mask 5 from the initial growth layer.

Of the first semiconductor part 8A, the first base B1 located above the first opening K1 serves as a dislocation inheriting portion in which a large number of threading dislocations occur, and the first wing F1 located above the mask 5 serves as a low defect portion having a lower threading dislocation density than that of the dislocation inheriting portion.

The template substrate TS may include a second seed region S2 adjacent to the first seed region S1 in a first direction X1 with the growth suppression region DA interposed therebetween. The mask pattern 6 may include a second opening K2 corresponding to the second seed region S2. In the template substrate TS, each of the first seed region S1 and the growth suppression region DA arranged side by side in the first direction X1 may have a shape whose longitudinal direction takes a second direction X2 orthogonal to the first direction X1.

The semiconductor substrate 10 of the present embodiment may include a second semiconductor part 8C including a nitride semiconductor. The second semiconductor part 8C is located above the second seed region S2 and above the growth suppression region DA. The second semiconductor part 8C may include a second base B2 located above the second seed region, and a second wing F2 contact to the second base B2 and located above the growth suppression region DA. The first wing F1 and the second wing F2 may be arranged side by side in the first direction X1 with a gap GP interposed therebetween.

The second semiconductor part 8C may laterally grow on the mask 5 while taking the second seed region S2 exposed in the second opening K2 as a starting point, and the growth may be stopped before the second semiconductor 8C meets the first semiconductor part 8A. This makes the semiconductor substrate 10 have the gap GP between the first semiconductor part 8A and the second semiconductor part 8C. Similarly to the first semiconductor part 8A described above, of the second semiconductor part 8C, the second base B2 located above the second opening K2 serves as a dislocation inheriting portion, and the second wing F2 located above the mask 5 serves as a low defect portion.

In the following description, the first and second semiconductor parts 8A and 8C may be collectively referred to as a semiconductor part 8, the first and second bases B1 and B2 may be collectively referred to as a base B, and the first and second wings F1 and F2 may be collectively referred to as a wing F. The first opening K1 and second opening K2 of the mask pattern 6 may be collectively referred to as an opening K, and the first seed region S1 and second seed region S2 may be collectively referred to as a seed region S. The semiconductor part 8 may be a semiconductor layer 8, and the mask 5 may be a mask layer 5.

Hereinafter, a direction from the main substrate 1 toward the semiconductor part 8 may be referred to as an "upper direction", and viewing an object with a line of sight parallel to a normal direction of the semiconductor substrate 10 (including viewing an object in a see-through manner) may be referred to as "plan view". The seed region S and the growth suppression region DA may be arranged side by side in the first direction X1 (a direction orthogonal to a thickness direction of the substrate) in plan view. The seed region S (e.g., the surface of the Al-based nitride layer 2) and the growth suppression region DA (e.g., the surface of the mask 5) may be different from each other in position (height) in the thickness direction (up-down direction) of the semiconductor substrate 10, or may be equal or substantially equal to each other in height.

The first direction X1 may be an a-axis direction (<11-20> direction) of the semiconductor part 8 (nitride semiconductor crystal such as GaN). The second direction X2 orthogonal to the first direction X1 may be an m-axis direction (<1-100> direction) of the semiconductor part 8. The thickness direction of the semiconductor substrate 10 may be a c-axis direction (<0001> direction) of the semiconductor part 8.

Since the semiconductor substrate 10 of the present embodiment includes the metal layer ML above the main substrate 1 and the Al-based nitride layer 2 is formed on the metal layer ML, a warp of the semiconductor substrate 10 can be reduced, for example. This will be schematically described together with the outline of findings of the present disclosure.

A known template substrate (hereinafter, referred to as a "known template substrate C" for convenience of description) includes, for example, a base substrate including a silicon substrate, an AlN layer as a buffer layer, an AlGaN layer as a strain relaxation layer, and a GaN underlying layer in this order. The known template substrate C includes a mask pattern formed on the base substrate. The AlN layer mentioned above is provided to suppress melting (meltback) of the silicon substrate and the GaN underlying layer, and to improve the quality of the GaN underlying layer. In general, the AlN layer is formed by the MOCVD method from the viewpoint, and the like, of improving the quality as a buffer layer.

In the semiconductor substrate manufactured by loading the known template substrate C into an MOCVD device and forming the GaN layer by using the ELO method, when the temperature is lowered from the film-forming temperature, a warp is likely to occur due to a difference in thermal expansion coefficient between the silicon substrate and the GaN layer. The known template substrate C uses an inexpensive silicon substrate but is formed by the MOCVD method, which makes it difficult to reduce the manufacturing cost.

The AlN layer can be formed on the silicon substrate by a sputtering (physical vapor deposition) method instead of the MOCVD method. However, it has been difficult to form a high-quality AlN layer on a silicon substrate by the sputtering method. As a result of intensive studies, the present inventors have found that when a relatively thick metal layer ML is formed above the main substrate 1 such as a silicon substrate and an AlN layer is formed on this metal layer ML by the sputtering method, the quality of the AlN layer can be improved. No template substrate using a metal layer ML with a thickness exceeding about 5 nm has been provided as an underlying base for forming an AlN layer by the sputtering method, and the significance of such a template substrate has been unknown.

The reason why the quality of the AlN layer is improved by using the metal layer ML thicker than the known metal layer as an underlying base for the growth can be considered as follows: the crystal state (lattice strain, residual stress, or the like) of the metal layer ML may have an influence on the quality of the AlN layer. The inventors have also found that the quality of an Al-based nitride having a structure equivalent to that of AlN can be improved by using the metal layer ML thicker than the known metal layer as an underlying base for the growth.

The metal layer ML may include a layer containing Al as a main component (Al-based metal layer). In this case, the main component refers to such a metal element that the number of moles contained in the metal layer ML is the maximum. The metal layer ML may contain one or more metals selected from the group consisting of aluminum, platinum, palladium, silver, gold, hafnium, scandium, yttrium, titanium, and zirconium, and may contain any metal selected from the above group as a main component. The metal layer ML contains at least one metal in which the (111) plane of a face-centered cubic lattice or a body-centered cubic lattice or the (0001) plane of a hexagonal close-packed lattice is oriented to a main surface 1a of the main substrate 1. The metal layer ML may be an alloy.

The metal layer ML may be formed by the sputtering method, and in this case, the metal layer ML contains argon. By successively forming the metal layer ML and the Al-based nitride layer 2 in a sputtering device, the manufacturing efficiency of the template substrate TS can be improved.

When the AlN layer is formed by using the MOCVD method as in the related art, the film-forming process is carried out at a high temperature exceeding the melting point of the Al film as a metal layer, for example, which makes it difficult to manufacture the template substrate TS including the metal layer ML. In contrast, in the sputtering method, the film-forming temperature can be lowered, which makes it easy to manufacture the template substrate TS including the metal layer ML.

The metal layer ML may be located to overlap the entire upper surface (main surface 1a) of the main substrate 1 in plan view seen in the normal direction of the main substrate 1. The Al-based nitride layer 2 may be located to overlap the mask 5. The thickness of the metal layer ML may be equal to or greater than 20 nm, or may be in a range from 100 nm to 2000 nm.

The Al-based nitride layer 2 contains at least aluminum and nitrogen. The Al-based nitride layer 2 may contain a metal other than aluminum, and may contain, for example, scandium (Sc) or zirconium (Zr). The Al-based nitride layer 2 may be, for example, AlScN or AlZrN. The Al-based nitride layer 2 may contain a plurality of types of metals, and in this case, the content of aluminum may be largest among the plurality of types of metals, or the content of aluminum may be larger than the total content of types of metals other than aluminum.

The Al-based nitride layer 2 may be located to overlap the entire upper surface of the main substrate 1 in plan view seen in the normal direction of the main substrate 1. The Al-based nitride layer 2 may be located to overlap the entire upper surface (surface MLS) of the metal layer ML in plan view. The thickness of the Al-based nitride layer 2 may be, for example, 30 nm or more. The thickness of the Al-based nitride layer 2 may be greater than that of the metal layer ML, and may be, for example, in a range from 30 nm to 500 nm.

In the semiconductor substrate 10 of the present embodiment, an internal stress of the Al-based nitride layer 2 can be adjusted by adjusting processing conditions of the sputtering method. For example, the Al-based nitride layer 2 contains argon mixed when the layer is formed by the sputtering method. Therefore, the stress state of the Al-based nitride layer 2 at room temperature can be changed by changing the content of argon. For example, in the semiconductor substrate 10 at ambient temperature, the Al-based nitride layer 2 may be in a compressive stress state, and the semiconductor part 8 (first semiconductor part 8A) may be in a tensile stress state. In this case, a warp of the entire semiconductor substrate 10 can be reduced, which is effective for subsequent processes (e.g., device layer formation and peeling). In the semiconductor substrate 10 at the ambient temperature, the Al-based nitride layer 2 and the semiconductor part 8 (first semiconductor part 8A) may be in a tensile stress state. When the lattice constant of the Al-based nitride layer 2 is smaller than the lattice constant of the semiconductor part 8, the lattice interval in a plane orthogonal to the c-axis is widened because the Al-based nitride layer 2 is in the tensile stress state, so that the influence of a difference in lattice constant between the Al-based nitride layer 2 and the semiconductor part 8 is alleviated. As a result, crystallinity of the semiconductor part 8 (in particular, the base on the seed region S) can be enhanced. The metal layer ML and the Al-based nitride layer 2 may be in the tensile stress state. When the Al-based nitride layer 2 is an aluminum nitride layer (AlN layer), the ratio of impurity metal elements other than aluminum to all the metal elements in the AlN layer may be less than 0.5 atm%. The ambient temperature is typically room temperature, and is 20°C or 25°C, for example. The above-discussed stress states (the compressive stress state and the tensile stress state) are each defined based on a state of occurrence of an internal stress in a plane where the first direction X1 and the second direction X2 are taken as in-plane directions. The stress state in the height direction of the semiconductor substrate 10 may be different from the stress state in the plane where the first direction X1 and the second direction X2 are taken as the in-plane directions.

The semiconductor substrate 10 can be manufactured by manufacturing the template substrate TS, in which the Al-based nitride layer 2 of relatively high quality is formed by the sputtering method, and then film-forming the semiconductor part 8 on the template substrate TS. The semiconductor part 8 can have the same level of quality as in the case of being formed on the known template substrate C including the AlN layer formed by the MOCVD method. In the semiconductor substrate 10, the internal stress is alleviated by the Al-based nitride layer 2 located between the main substrate 1 and the semiconductor part 8. As a result, a warp that occurs in the semiconductor substrate 10 in a room temperature state can be effectively reduced.

In the semiconductor substrate 10, the nitride semiconductor included in the semiconductor part 8 may be a GaN-based semiconductor, and the main substrate 1 of the template substrate TS may be a silicon substrate or a silicon carbide substrate, or a glass substrate. A thermal expansion coefficient at 1000°C of the Al-based nitride layer 2 may be larger than that of the main substrate 1 and smaller than that of the semiconductor part 8 (first semiconductor part 8A).

The material of the above-mentioned glass substrate is not particularly limited as long as the glass substrate is made of a material having heat resistance against a film-forming temperature at which the semiconductor part 8 is formed by the ELO method. By forming the template substrate TS by the sputtering method using an inexpensive heterogeneous substrate as the main substrate 1, the manufacturing cost of the template substrate TS can be effectively reduced.

### Manufacturing Method of Semiconductor Substrate

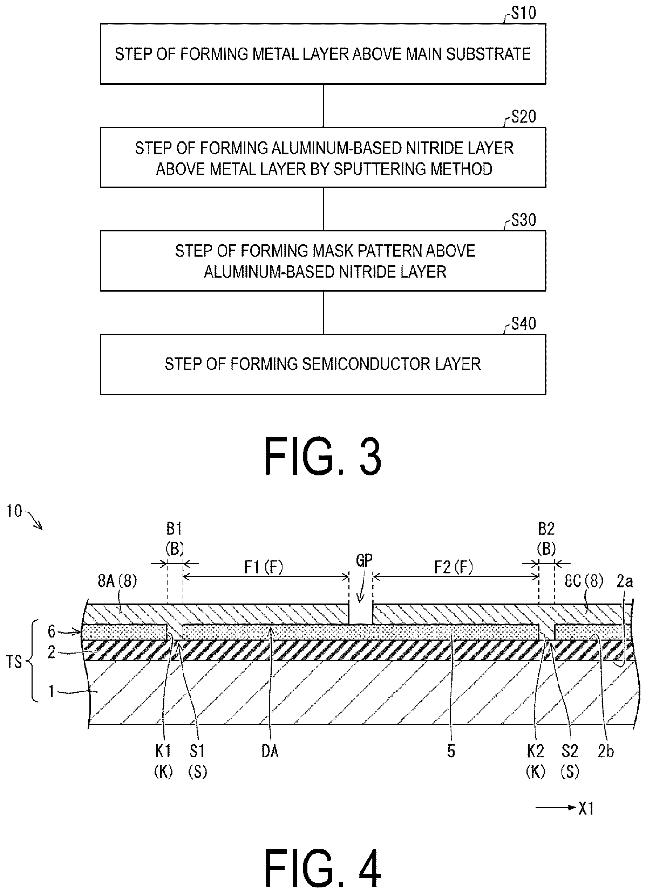

FIG. 3 is a flowchart illustrating an example of a method for manufacturing the semiconductor substrate 10 in the present embodiment. The flowchart illustrated in FIG. 3 also includes an example of a method for manufacturing the template substrate TS.

As illustrated in FIG. 3, in the manufacturing method of the semiconductor substrate 10, the template substrate TS is formed first. The manufacturing method of the template substrate TS includes a step of forming the metal layer ML above the main substrate 1 (S10), and
a step of forming the Al-based nitride layer 2 above the metal layer ML by using the sputtering method (S20). Subsequently, a step of forming the mask pattern 6 including the mask 5 configured to function as the growth suppression region DA above the Al-based nitride layer 2 (S30) may be carried out. Thereafter, a step of forming the semiconductor part 8 (S40) is carried out, whereby the semiconductor substrate 10 can be manufactured. For example, the metal layer ML may be an aluminum layer, and the aluminum layer may be formed using the sputtering method.

### Other Embodiments

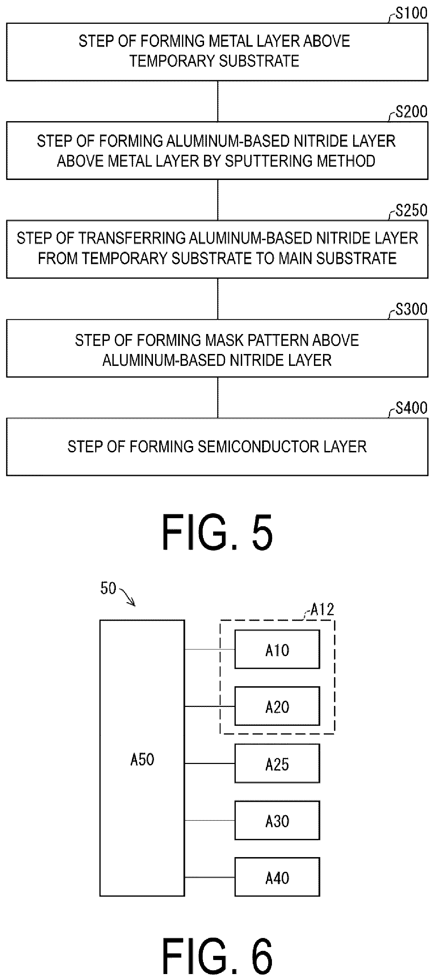

FIG. 4 is a cross-sectional view schematically illustrating a configuration of a semiconductor substrate 10 in another embodiment of the present disclosure. FIG. 5 is a flowchart illustrating an example of a manufacturing method of a semiconductor substrate 10 in another embodiment of the present disclosure. As illustrated in FIGs. 4 and 5, the template substrate TS need not have the metal layer ML, and such template substrate TS can be formed by forming the metal layer ML and the Al-based nitride layer 2 on another substrate (temporary substrate) different from the main substrate 1 and transferring the Al-based nitride layer 2 onto the main substrate 1. As the temporary substrate, a substrate made of a material suitable for film-forming the metal layer ML and the Al-based nitride layer 2 may be used.

In the example illustrated in FIG. 4, the semiconductor substrate 10 includes the template substrate TS including the first seed region S1 and the growth suppression region DA, and the first semiconductor part 8A; the template substrate TS includes the main substrate 1 and the Al-based nitride layer 2. The Al-based nitride layer 2 has a nitrogen polar plane bonded to the main substrate 1 and contains argon. The first semiconductor part 8A includes a nitride semiconductor.

In the present specification, the top side surface (growth surface) of the Al-based nitride layer 2 formed on the metal layer ML is referred to as a first surface 2a, and the surface located on the side opposite to the first surface 2a, that is, the surface on the side where the growth from the metal layer ML is started is referred to as a second surface 2b. In the example illustrated in FIG. 4, since the Al-based nitride layer 2 formed above the temporary substrate is transferred to the main substrate 1, the first surface 2a is a facing surface that faces the main substrate 1, and the second surface 2b is located on the side far from the main substrate 1. The second surface 2b of the Al-based nitride layer 2 exposed in the opening K serves as the seed region S.

The first surface (top side surface) 2a of the Al-based nitride layer 2 built by c-plane growth on the metal layer ML may be an aluminum polar plane (Al polar plane). When the Al-based nitride layer 2 is built by -c-plane growth on the metal layer ML, the first surface 2a may be a nitrogen polar plane (N polar plane). For example, the first surface 2a of the Al-based nitride layer 2 in a state of being formed on the temporary substrate by the sputtering method may be an N polar plane, and the N polar plane may be bonded to the main substrate 1 after the transfer to the main substrate 1. This will be described in more detail through examples described later.

In the example illustrated in FIG. 5, a method for manufacturing the template substrate TS includes a step of forming the metal layer ML above the temporary substrate (S100), a step of forming the Al-based nitride layer 2 by the sputtering method above the metal layer ML (S200), and a step of transferring the Al-based nitride layer 2 from the temporary substrate to the main substrate 1 (S250). For example, the main substrate 1 and the Al-based nitride layer 2 can be bonded by surface activity. By removing the metal layer ML, the main substrate 1 and the Al-based nitride layer 2 can be isolated from the temporary substrate. Then, a step of forming the mask pattern 6 above the Al-based nitride layer 2 (S300) may be carried out. Thereafter, a step of forming the semiconductor part 8 (S400) is carried out, whereby the semiconductor substrate 10 can be manufactured. For example, the metal layer ML may be an aluminum layer, and the aluminum layer may be formed using the sputtering method. After the step of S250, a semiconductor device can be formed by carrying out a step of forming electrodes or the like in place of the steps of S300 and S400.

In the template substrate TS manufactured by the manufacturing method of the example depicted in FIG. 5, the Al-based nitride layer 2 is transferred from the temporary substrate to the main substrate 1, and thus does not inherit the crystal structure of the main substrate 1 at the interface with the main substrate 1. The semiconductor substrate 10 may have a bonding trace at the interface between the Al-based nitride layer 2 and the main substrate 1. The bonding trace may be a trace of bonding between the main substrate 1 and the Al-based nitride layer 2, which indicates a difference between the Al-based nitride layer 2 in a case of having epitaxially grown on the main substrate 1 and the Al-based nitride layer 2 having been transferred to the main substrate 1. The bonding trace is not particularly limited; for example, in a case where the plane orientation of the surface of the main substrate 1 and the plane orientation of the first surface 2a of the Al-based nitride layer 2 are not aligned with each other based on an XRD measurement result or the like, the bonding trace may be determined to be included.

### Manufacturing Apparatus of Semiconductor Substrate

FIG. 6 is a block diagram illustrating an example of a manufacturing apparatus 50 in an embodiment of the present disclosure. The manufacturing apparatus 50 illustrated in FIG. 6, for manufacturing the semiconductor substrate 10, includes a device A10 for carrying out the step of S10, a device A20 for carrying out the step of S20, a device A30 for carrying out the step of S30, a device A40 for carrying out the step of S40, and a device A50 for controlling the devices A10 to A40. The device A10 may carry out the step of S100, and the device A20 may carry out the step of S200. The manufacturing apparatus 50 may include a device A25 for carrying out the step of S250. The device A50 may control the device A25. The device A30 may carry out the step of S300, and the device A40 may carry out the step of S400.

The device A10 and the device A20 may each include a sputtering device. The manufacturing apparatus 50 may include a single device A12 having functions of the devices A10 and A20, and the device A12 may include a sputtering device. The device A50 may control the device A12. The device A50 may include a processor and a memory. The device A50 may be configured to, for example, control the device A10 and device A20 by executing a program stored in a built-in memory, a communicable communication device, or an accessible network; the present embodiment also includes the program and a recording medium storing the program therein.

### Semiconductor Device

The semiconductor part 8 in the semiconductor substrate 10 includes the wing F as a low defect portion. The wing F can be used to form a semiconductor device. Specific examples of the semiconductor device include a light-emitting component (e.g., an LED chip or a semiconductor laser chip), a light-emitting element in which the light-emitting component is sub-mounted, and a light-emitting module in which the light-emitting element is packaged. The semiconductor device is not limited to a light-emitting semiconductor device, and may be, for example, a light receiving element (e.g., a photo diode).

### Other Embodiments

Other embodiments of the present disclosure will be schematically described as follows. More detailed description will be given in examples to be described later.
(a) The metal layer ML may be made of a single layer or multiple layers including the above-described types of metals. When the metal layer ML is made of multiple layers, at least one layer may contain aluminum as a main component, and a layer (uppermost layer) in contact with the Al-based nitride layer 2 may contain aluminum as a main component. The metal layer ML may include a first layer made of a metal material and a second layer made of a metal material different from that of the first layer. The first layer and the second layer may each contain one or more metals selected from the group consisting of aluminum, platinum, palladium, silver, gold, hafnium, scandium, yttrium, titanium, and zirconium.
(b) In the template substrate TS, the seed region S may be a region serving as a starting point of growth of the semiconductor part 8; the template substrate TS may include the seed region S and the growth suppression region DA above the main substrate 1. The template substrate TS need not include, for example, the mask 5.
(c) The semiconductor substrate 10 of a configuration example may include a metal nitride layer located between the metal layer ML and the Al-based nitride layer 2.
(d) Although the semiconductor substrate 10 in the above-described embodiment includes the semiconductor part 8 formed by the ELO method, the present disclosure is not limited thereto. In the semiconductor substrate 10 according to another aspect of the present disclosure, the template substrate TS need not include the mask pattern 6. The template substrate TS can be used for manufacturing a semiconductor device other than an optical system; examples of such a semiconductor device include a transistor such as a high electron mobility transistor (HEMT), and an element for micro electro mechanical systems (MEMS) such as a bulk acoustic wave (BAW) filter.
(e) The semiconductor substrate 10 in an aspect of the present disclosure may include a vacant space between the wing F and the mask 5 serving as the growth suppression region DA; for example, the seed region S may be located above the growth suppression region DA in the thickness direction of the semiconductor substrate 10.
(f) In the semiconductor substrate 10 according to an aspect of the present disclosure, the semiconductor parts 8 respectively laterally grown in opposite directions from the first opening K1 and the second opening K2 adjacent to each other in the first direction X1 may be in contact with (may meet) each other on the mask 5. The semiconductor substrate 10 need not include the gap GP.

### Example 1

Hereinafter, the template substrate TS before the semiconductor part 8 is formed will be described first, and then the semiconductor substrate 10 will be described.

### Template Substrate

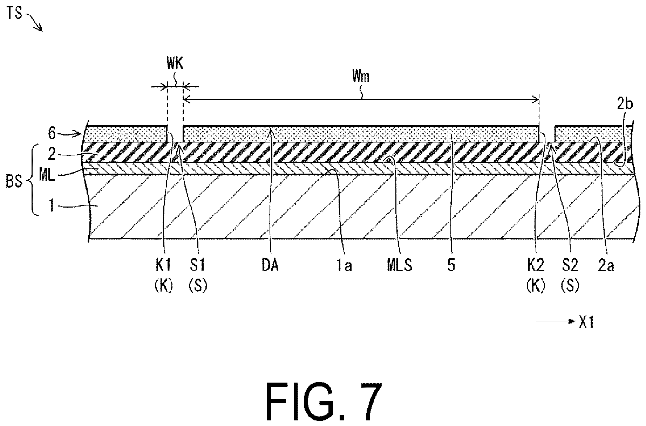

FIG. 7 is a cross-sectional view schematically illustrating a configuration of the template substrate TS in Example 1. As illustrated in FIG. 7, the template substrate TS in Example 1 may have the same schematic configuration as that of the template substrate TS in the first embodiment. The template substrate TS may include a base substrate BS including a main substrate 1, a metal layer ML, and an Al-based nitride layer 2; a mask pattern 6 may be formed on the base substrate BS.

The main substrate 1 may be made of a silicon substrate or may be made of various types of glass substrates. The plane orientation of the main substrate 1 is, for example, the (111) plane of a silicon substrate. However, these are merely examples, and the main substrate 1 in Example 1 may have a material and a plane orientation that satisfy the following two conditions, and the specific material and plane orientation of the main substrate 1 are not necessarily limited. That is, first, the main substrate 1 is required to make it possible to manufacture the base substrate BS by forming the metal layer ML and the Al-based nitride layer 2 above the main substrate 1. Second, the main substrate 1 is required to make it possible to grow the semiconductor part 8 by the ELO method using the template substrate TS, which is manufactured by forming the mask pattern 6 above the base substrate BS including the main substrate 1. By using an inexpensive substrate as the main substrate 1, the manufacturing cost of the template substrate TS and the semiconductor substrate 10 can be effectively reduced.

A silicon carbide (SiC) substrate can also be used as the main substrate 1, which is a heterogeneous substrate. In this case, the plane orientation of the main substrate 1 may be the 6H-SiC (0001) or 4H-SiC (0001) plane of the SiC substrate. The main substrate 1 may be 3C-SiC. In a case where the use of an inexpensive substrate is not so important, the main substrate 1 may be a sapphire substrate or a nitride substrate (e.g., a GaN substrate).

The metal layer ML may be formed on the main substrate 1. The metal layer ML may be formed above the main substrate 1, and a heterogeneous layer made of a material different from that of the main substrate 1 and that of the metal layer ML may be interposed between the main substrate 1 and the metal layer ML. In Example 1, the metal layer ML may overlap the entirety of a main surface 1a of the main substrate 1 in plan view. Since the template substrate TS includes the metal layer ML and the Al-based nitride layer 2, even when a silicon substrate or the like is used as the main substrate 1, a possibility of occurrence of a problem in which silicon and gallium react with each other at a high temperature (so-called meltback) can be lowered.

In Example 1, the metal layer ML may be an Al layer, and the thickness of the metal layer ML is equal to or greater than 20 nm, for example. This makes it possible to improve the quality of the Al-based nitride layer 2 formed on the metal layer ML. The Al layer as the metal layer ML may be formed by growing Al having a face-centered cubic structure in a <111> direction from the main surface 1a of the main substrate 1 (e.g., from the (111) plane of the silicon substrate). In this case, a surface MLS of the metal layer ML on a side far from the main substrate 1 is the (111) plane in the face-centered cubic structure.

The Al-based nitride layer 2 has a wurtzite structure. Since the (111) plane in a face-centered cubic structure corresponds to an atomic arrangement of a hexagonal system, the Al-based nitride layer 2 can be epitaxially grown in the c-axis direction from the surface MLS of the metal layer ML. At the interface between the Al-based nitride layer 2 and the metal layer ML, the surface MLS and a second surface 2b have plane orientations corresponding to each other. Such Al-based nitride layer 2 can be expressed as inheriting the crystal structure of the metal layer ML.

The metal layer ML may contain at least one metal in which the (111) plane of a face-centered cubic lattice or a body-centered cubic lattice, or the (0001) plane of a hexagonal close-packed lattice is oriented to the main surface 1a of the main substrate 1. Examples of such a metal include, in addition to aluminum, platinum, palladium, silver, gold, hafnium, scandium, yttrium, titanium, and zirconium. Thus, the surface MLS of the metal layer ML can be made to be the (111) plane of a face-centered cubic lattice or a body-centered cubic lattice, or the (0001) plane of a hexagonal close-packed lattice, and the Al-based nitride layer 2 can be easily grown from the surface MLS.

When the thickness of the metal layer ML is made large in a range in which the layer thickness of the metal layer ML is 20 nm or more, the Al-based nitride layer 2 can be improved in quality (for example, orientation). The quality of the Al-based nitride layer 2 can be evaluated by, for example, measuring an X-ray rocking curve of the Al-based nitride layer 2 after film formation. When the metal layer ML is as thick as about 1000 nm, the influence of the thickness of the metal layer ML on the quality of the Al-based nitride layer 2 may be reduced. The thickness of the metal layer ML may be in a range from 20 nm to 2000 nm, or may be in a range from 100 nm to 2000 nm.

According to the studies by the present inventors, for example, when an AlN layer as the Al-based nitride layer 2 was formed on an Al film as the metal layer ML, and the relationship between the thickness of the Al film and a half-value width of the X-ray rocking curve measurement result of the AlN layer was investigated, there was a tendency that the larger the thickness of the Al film, the smaller the half-value width was and the higher the quality of the AlN layer was. Since the film-formation time of the Al film (that is, the thickness of the Al film) is related to the manufacturing cost, the thickness of the Al film can be set in consideration of the balance between the manufacturing cost and the quality of the AlN layer.

In Example 1, the Al-based nitride layer 2 may be an AlN layer, and the AlN layer may be, for example, 30 nm or more in thickness. The thickness of the AlN layer may be larger than that of the Al film as the metal layer ML, and may be in a range from 30 nm to 500 nm, for example.

In Example 1, the metal layer ML and the Al-based nitride layer 2 can be successively formed by the sputtering method in a sputtering device. As a scheme of sputtering, DC sputtering, RF sputtering, AC sputtering, DC magnetron sputtering, electron cyclotron resonance (ECR) sputtering, an RF magnetron sputtering method, a pulse sputter deposition (PSD) method, a laser ablation method, or the like can be selected as appropriate.

The metal layer ML formed by the sputtering method may contain argon derived from an argon gas introduced into the sputtering device. Argon may be detected by secondary ion mass spectrometry (SIMS) depending on a metal type contained in the metal layer ML.

For example, the degree of vacuum in the sputtering device before film formation may be equal to or lower than 3 × 10⁻⁵ Pa or equal to or lower than 1 × 10⁻⁵ Pa. By making the main substrate 1 subjected to pretreatment before the film-forming process is started, an organic substance layer and irregularities on the main surface 1a of the main substrate 1 may be removed, and the epitaxial growth of the metal layer ML may be enabled. Specific examples of the pretreatment include a reverse sputtering treatment, an acid treatment, and a UV treatment. The reverse sputtering treatment is a method in which atoms turned into plasma are caused to collide with the main substrate 1 side to clean the main surface 1a of the main substrate 1, and has an advantage that reattachment of impurities or the like is easily suppressed after the treatment. The substrate temperature during the film formation may be set to room temperature. However, carrying out the film formation with the main substrate 1 being heated makes it possible to further improve film quality. When the main substrate 1 is heated, the heating temperature can be adjusted in accordance with the material of the metal layer ML. For example, the heating temperature may be in a range from 700°C to 900°C.

Since the Al-based nitride layer 2 is formed on the metal layer ML by the sputtering method, the Al-based nitride layer 2 has higher quality than in a case of being formed directly on the main substrate 1 by the sputtering method. The Al-based nitride layer 2 contains argon derived from an argon gas introduced into the sputtering device. The argon content in the Al-based nitride layer 2 may be in a range from 0.01 atm% to 1.0 atm%, for example.

When the metal layer ML and the Al-based nitride layer 2 are formed by the sputtering method, the internal stress of the metal layer ML and the Al-based nitride layer 2 can be controlled by film formation conditions. For example, by controlling the amount of argon incorporated into the film, the internal stress can be changed from a compressive stress to a tensile stress. With this, in the semiconductor substrate 10, the mutual stress relationship between the template substrate TS and the semiconductor part 8 formed on the template substrate TS can be adjusted. This makes it possible to reduce a warp of the semiconductor substrate 10.

The mask pattern 6 is formed on the base substrate BS by using a material that suppresses longitudinal growth (growth in the c-axis direction) of the nitride semiconductor, and achieves lateral growth (e.g., growth in the a-axis direction) of the nitride semiconductor.

Examples of the material of a mask 5 of the mask pattern 6 include silicon nitride, silicon carbide, silicon carbonitride, diamond-like carbon, silicon oxide, and silicon oxynitride. In addition, examples of the material of the mask 5 include titanium nitride, molybdenum nitride, tungsten nitride, and tantalum carbide, which do not contain silicon, and further include high melting point metals (molybdenum, tungsten, platinum, and the like). The mask 5 may be a single layer film made of one of these materials, or a multi-layer film achieved by combining a plurality of these materials. The thickness of the mask 5 may be approximately 100 nm to 4 µm, for example. A width Wm (size in the first direction X1) of the mask 5 may be, for example, 10 µm to 200 µm. In Example 1, the width Wm of the mask 5 may be smaller than the size of the metal layer ML or the Al-based nitride layer 2 in the first direction X1.

An opening K (an exposed portion of a seed region S) of the mask pattern 6 serves as a growth starting point of the semiconductor part 8. The opening K may have a longitudinal shape in which the first direction X1 is taken as a width direction and the second direction X2 (see FIG. 1) is taken as a longitudinal direction. In the mask pattern 6, a plurality of the openings K may be arranged side by side in the first direction X1. The opening K may have a tapered shape (shape that narrows downward). A width WK (size in the first direction X1) of the opening K may be, for example, approximately 0.1 µm to 20 µm. The width WK of the opening K may be smaller than the width Wm of the mask 5.

### Manufacturing Method of Template Substrate

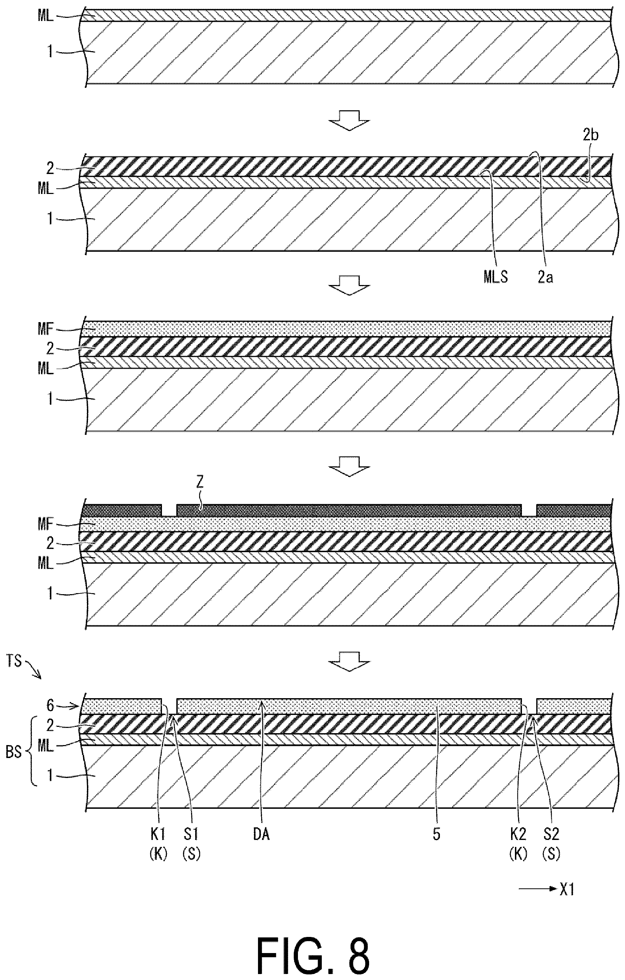

FIG. 8 is a cross-sectional view illustrating a manufacturing method of the template substrate TS in Example 1. For example, a silicon substrate (Si (111) plane) is used as the main substrate 1. An Al film can be formed on the silicon substrate by sputtering an Al target while introducing an Ar gas in the sputtering device. For example, the thickness of the Al film may be 100 nm, the film-forming temperature of the Al film may be 400°C, the input power may be 500 W, and the back pressure during film formation may be 0.3 Pa.

Subsequently, an AlN film can be formed on the Al film by sputtering the Al target while introducing a mixed gas of argon gas and nitrogen gas (e.g., the gas ratio is about 1:1) into the sputtering device. In this manner, the Al film and the AlN film can be successively formed without putting in and taking out the substrate in the same chamber.

In general, for example, when an AlN film is made to epitaxially grow on a sapphire substrate, the AlN film grows in the [0001] direction, and the outermost surface becomes an Al polar plane. In contrast, in the template substrate TS in Example 1, a first surface 2a of the AlN film may be an N polar plane. The reason for this can be considered as follows: the AlN film as the Al-based nitride layer 2 can be epitaxially grown in the [000-1] direction from the surface MLS on the Al film as the metal layer ML. The first surface 2a of the Al-based nitride layer 2 may be an N polar plane or a plane where an Al polar plane and an N polar plane are mixed (mixed polarity).

Subsequently, a mask layer MF (e.g., SiN) having a thickness of 300 nm is formed on the Al-based nitride layer 2 by the sputtering method. Then, a resist is applied on the entire mask layer MF, and thereafter the resist is patterned by the photolithography technique to form a resist Z including a plurality of openings each having a stripe shape of approximately 3 µm in width. Subsequently, some portions in the mask layer MF are removed by a wet etchant such as hydrofluoric acid (HF) or buffered hydrofluoric acid (BHF) to form a plurality of the openings K, and the resist Z is removed by organic cleaning to form the mask pattern 6.

In a case where the Al-based nitride layer 2 is formed by the MOCVD method, the GaN layer may also be formed in the MOCVD device. Therefore, Ga may be present in the MOCVD device, and in this case, Ga may adhere to the main substrate 1. When meltback occurs due to the adhering Ga, the yield decreases. Accordingly, the maintenance of the MOCVD device and the work such as cleaning of the components (e.g., a tray and a cover) inside the device need to be performed at a high frequency, resulting in an increase in cost. On the other hand, when the Al-based nitride layer 2 is formed by the sputtering method, the surface of the main substrate 1 is covered with the metal layer ML, the Al-based nitride layer 2, and the mask pattern 6 at the time when the main substrate 1 is loaded into the MOCVD device for forming the semiconductor part 8. Because of this, the possibility that Ga adheres to the surface of the main substrate 1 can be lowered, and the possibility of a drop in manufacturing yield due to the occurrence of meltback can be lowered. This brings a significant industrial advantage.

### Semiconductor Substrate

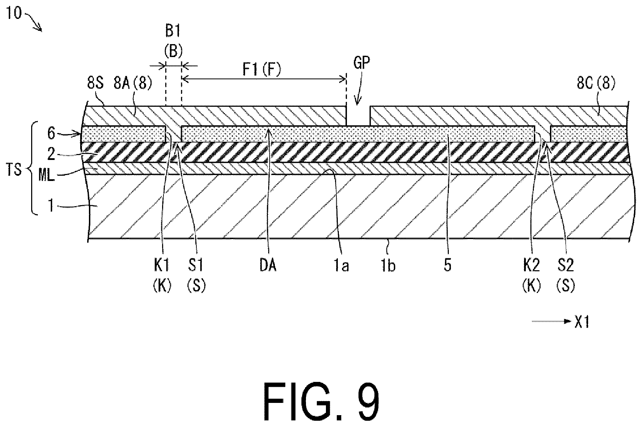

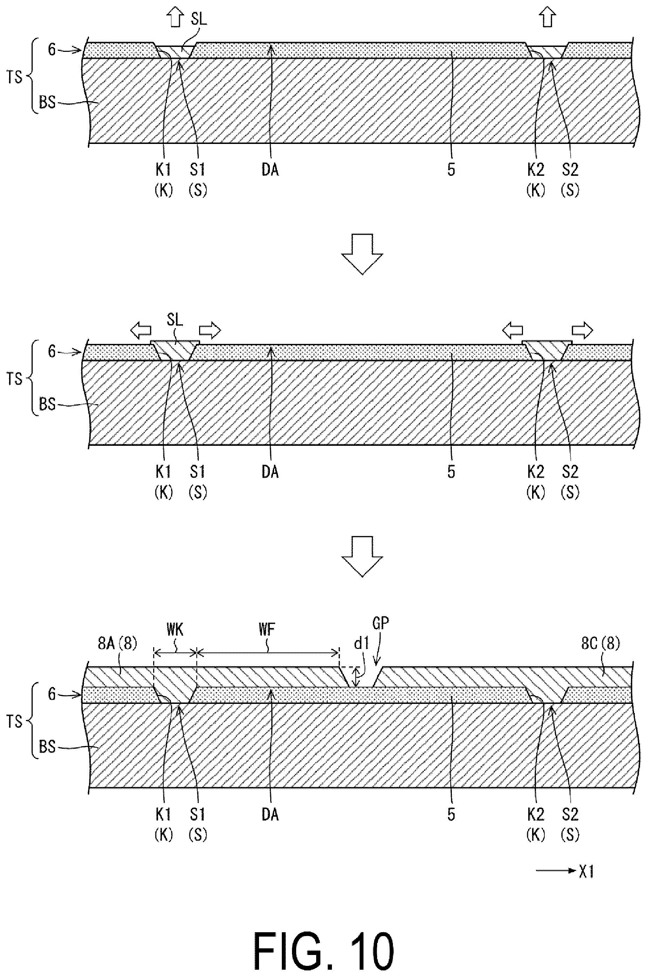

FIG. 9 is a cross-sectional view schematically illustrating the configuration of the semiconductor substrate 10 in Example 1. FIG. 10 is a cross-sectional view illustrating an example of lateral growth of the semiconductor part 8. FIG. 10 illustrates an example in which the mask 5 in the mask pattern 6 has a tapered opening K. The semiconductor substrate 10 in Example 1 includes a first semiconductor part 8A and a second semiconductor part 8C formed by the ELO method above the template substrate TS.

In the example illustrated in FIG. 9, a base B of the semiconductor part 8 (first semiconductor part 8A, second semiconductor part 8C) is in contact with the first surface 2a of the Al-based nitride layer 2 in the opening K (first opening K1, second opening K2). The semiconductor part 8 may include an initial growth portion (initial stage growth portion) SL at a location in contact with the first surface 2a. The initial growth portion SL may be an initial growth layer SL.

The semiconductor part 8 formed by the ELO method can be laterally grown as follows. As illustrated in FIG. 10, the initial growth portion SL may be formed on the seed region S exposed from the opening K, and then the semiconductor part 8 may be laterally grown from the initial growth portion SL. The initial growth portion SL serves as a starting point of the lateral growth of the semiconductor part 8. The semiconductor part 8 can be controlled to grow in the c-axis direction or in the a-axis direction (first direction X1) of the nitride semiconductor by appropriately controlling an ELO film formation condition.

For example, the film formation of the initial growth portion SL may be stopped at a timing immediately before an edge of the initial growth portion SL rides on the upper surface of the mask 5 (a stage of being in contact with the upper end of a side surface of the mask 5) or immediately after the edge of the initial growth portion SL rides on the upper surface of the mask 5 (i.e., at this timing, the ELO film formation condition may be switched from a c-axis direction film formation condition to an a-axis direction film formation condition). By making the initial growth portion SL laterally grow from a state of being slightly protruding from the mask 5, the growth of the semiconductor part 8 in the c-axis direction (thickness direction) can be suppressed, the semiconductor part 8 can be laterally grown at high speed and with high crystallinity, and further the consumption of raw materials is reduced. This makes it possible to form the thin, wide, and low-defect semiconductor part 8 (a crystal body of a nitride semiconductor such as GaN) at low cost. The initial growth portion SL can be formed to have a thickness of, for example, 30 nm to 1000 nm, 50 nm to 400 nm, or 70 nm to 350 nm.

The semiconductor parts 8 respectively laterally grown in opposite directions from a first opening K1 and a second opening K2, which are adjacent to each other, are not in contact with (do not meet) each other on the mask 5 but have a gap (interval) GP, thereby making it possible to reduce the internal stress of the semiconductor part 8. This can reduce cracks and defects (dislocations) that may be produced in the semiconductor part 8. The width of the gap GP (size in the first direction X1) can be, for example, 5 µm or less, 3 µm or less, or 2 µm or less.

In the semiconductor part 8, the base B located on the initial growth portion SL serves as a dislocation inheriting portion in which a large number of threading dislocations occur, and a wing F located on the mask 5 serves as a low defect portion where a threading dislocation density is equal to or less than one-fifth the threading dislocation density of the dislocation inheriting portion. The threading dislocation is a dislocation (defect) extending in the semiconductor part 8 in its c-axis direction (<0001> direction). The threading dislocation density can be obtained by, for example, performing cathode luminescence (CL) measurement on the surface of the semiconductor part 8 and counting the number of black spots in the CL measurement image. The threading dislocation density of the wing F can be set to, for example, 5 × 10⁶ [spots/cm²] or less. As described below, when an active section (active layer) including a light-emitting portion is formed above the semiconductor part 8, the light-emitting portion can be disposed above the wing F (disposed to overlap the wing F in plan view).

Regarding the wing F, the ratio of a width WF (size in the first direction X1) to a thickness d1 (WF/d1) can be set to 2.0 or more, for example. The ratio WF/d1 can be 2.0 or more, 4.0 or more, 5.0 or more, 7.0 or more, or 10.0 or more. By setting WF/d1 to 2.0 or more in the semiconductor substrate 10, the internal stress of the semiconductor part 8 can be easily reduced. This makes it possible to reduce a warp of the semiconductor substrate 10. The width WF of the wing F may be, for example, equal to or larger than 7.0 µm, equal to or larger than 10.0 µm, equal to or larger than 20.0 µm, or equal to or larger than 40.0 µm. The thickness d1 can be not greater than 10.0 µm, not greater than 5.0 µm, or not greater than 2.0 µm.

The basal plane dislocation density of the base B may be (5 × 10⁸/cm²) or less. The basal plane dislocation may be a dislocation extending in an in-plane direction of the c-plane of the semiconductor part 8. In this case, the basal plane dislocation density can be obtained, for example, by splitting the semiconductor part 8 to expose a side surface of the base B and performing CL measurement for the dislocation density on the side surface.

The semiconductor part 8 need not contain argon. That the semiconductor part 8 does not contain argon means that the argon content in the semiconductor part 8 is less than 0.01 atm%. In this case, the base B or the initial growth portion SL in the semiconductor part 8 may contain a small amount of argon diffused from the Al-based nitride layer 2 due to being connected to the Al-based nitride layer 2. The wing F need not contain argon diffused from the Al-based nitride layer 2. In a case where argon is also contained in the wing F, the concentration of argon in the wing F may decrease as the position in the wing F is farther from the base B. For example, even when the semiconductor part 8 contains a trace amount of argon diffused from the Al-based nitride layer 2, the argon content in the semiconductor part 8 is less than 0.01 atm% (the semiconductor part 8 does not contain argon).

In Example 1, a GaN layer was taken as the semiconductor part 8, and the ELO film formation of gallium nitride (GaN) was performed on the above-described template substrate 7 by using the MOCVD device. The following can be adopted as examples of the ELO film formation conditions: substrate temperature: 1120°C, growth pressure: 50 kPa, trimethylgallium (TMG): 22 sccm, NH₃: 15 slm, and V/III = 6000 (ratio of group V raw material supply amount to group III raw material supply amount). In order to make the semiconductor part 8 be an n-type, doping may be performed using SiH₄. Alternatively, by using a material containing Si (e.g., SiO₂ or SiN) for the mask 5, Si doping can be performed utilizing Si evaporated from the mask 5. The width Wm of the mask 5 was 50 µm, the width WK of the opening K was 5 µm, the breadth of the semiconductor part 8 was 53 µm, the width WF of the wing F was 24 µm, and a layer thickness of the semiconductor part 8 was 5 µm. The aspect ratio of the semiconductor part 8 was (53 µm/5 µm = 10.6), and thus a significantly high aspect ratio was achieved.

The film-forming temperature of the semiconductor part 8 by the ELO method is preferably a temperature equal to or less than 1150°C, rather than a high temperature exceeding 1200°C. The semiconductor part 8 can be formed even at a low temperature below 1000°C, which is more preferable from the viewpoint of reducing mutual reactions. In Example 1, mutual diffusion may occur between the Al film as the metal layer ML and the main substrate 1 or the Al-based nitride layer 2. In the semiconductor substrate 10, the main substrate 1 may include an alloy layer (not illustrated) generated by a mutual reaction with the metal layer ML under the ELO film formation conditions. Alternatively, in the main substrate 1, the Al concentration at the main surface 1a may be higher than the Al concentration at a back surface 1b located on the opposite side to the main surface 1a. In the semiconductor substrate 10, the Al-based nitride layer 2 may have an Al-rich composition.

It has been found that, in the case where the semiconductor part 8 contains carbon, a reaction with the mask 5 can be reduced, and adhesion or the like between the mask 5 and the semiconductor part 8 can be reduced. Accordingly, in the low-temperature film formation of the semiconductor part 8, for example, the supply amount of ammonia is reduced and the film formation is performed at a substantially low V/III (< 1000), thereby making it possible to take carbon elements in the raw material or a chamber atmosphere into the semiconductor part 8 and to reduce the reaction with the mask 5. In the low-temperature film formation at a temperature below 1000°C, triethylgallium (TEG) is preferably used as a gallium raw material gas. Since an organic raw material in TEG is efficiently decomposed at a low temperature as compared with trimethyl gallium (TMG), the lateral film formation rate can be raised.

In Example 1, the first surface 2a of the Al-based nitride layer 2 may be an N polar plane or a surface in which an Al polar plane and an N polar plane are mixed (mixed polarity), and the first surface 2a may be the seed region S. Even in such a case, an upper surface 8S serving as the growth surface of the semiconductor part 8 can be changed to a gallium polar plane (Ga polar plane) by polarity inversion by various factors. Alternatively, the upper surface 8S may be an aluminum polar plane (Al polar plane). The semiconductor part 8 can be formed by adjusting the polarity of the upper surface 8S in such a manner as to be suitable for a device structure to be manufactured using the semiconductor substrate 10.

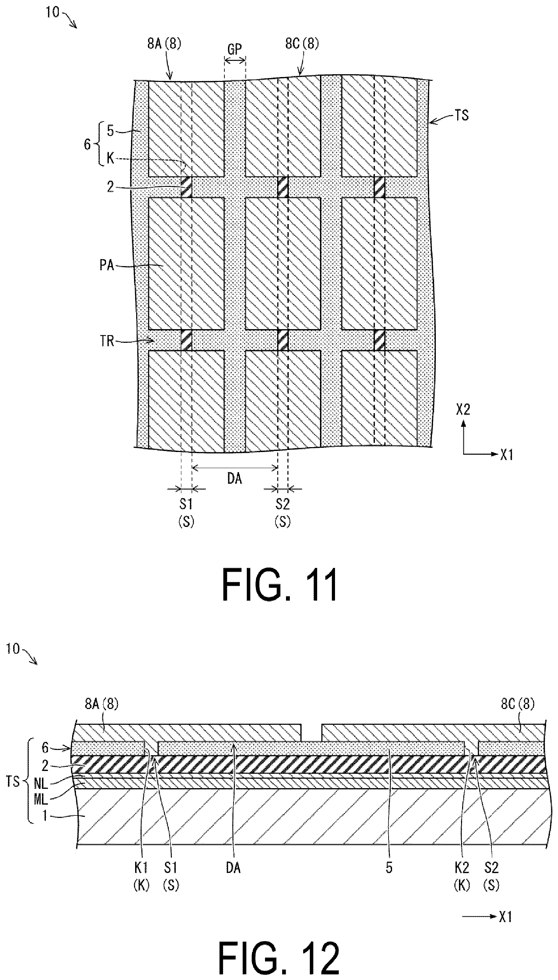

FIG. 11 is a plan view illustrating another configuration example of the semiconductor substrate 10 in Example 1. As illustrated in FIG. 11, the semiconductor part 8 of the semiconductor substrate 10 may be isolated into a plurality of parts PA arranged in the second direction X2 orthogonal to the first direction X1. A trench TR may be formed between the parts PA adjacent to each other in the second direction X2. The mask 5 and the Al-based nitride layer 2 may be exposed in the trench TR.

In the semiconductor substrate 10 of another example, the template substrate TS may have the opening K periodically divided in the second direction X2. In this case, the semiconductor part 8 may also be divided in the second direction X2.

FIG. 12 is a cross-sectional view illustrating another configuration example of the semiconductor substrate 10 in Example 1. As illustrated in FIG. 12, the template substrate TS in the semiconductor substrate 10 may include a metal nitride layer NL between the metal layer ML and the Al-based nitride layer 2. The metal nitride layer NL contains nitride of a metal other than aluminum. The metal nitride layer NL may include a material having a crystal structure close to that of the Al-based nitride layer 2. In this case, the Al-based nitride layer 2 may be easily epitaxially grown. The metal nitride layer NL may contain, for example, titanium nitride (TiN), zirconium nitride (ZrN), scandium nitride (ScN), or hafnium nitride (HfN). The metal nitride layer NL may be formed by the sputtering method, and in this case, the metal nitride layer NL may contain argon. The argon content in the metal nitride layer NL may be, for example, not less than 0.01 atm% and not more than 1.0 atm%.

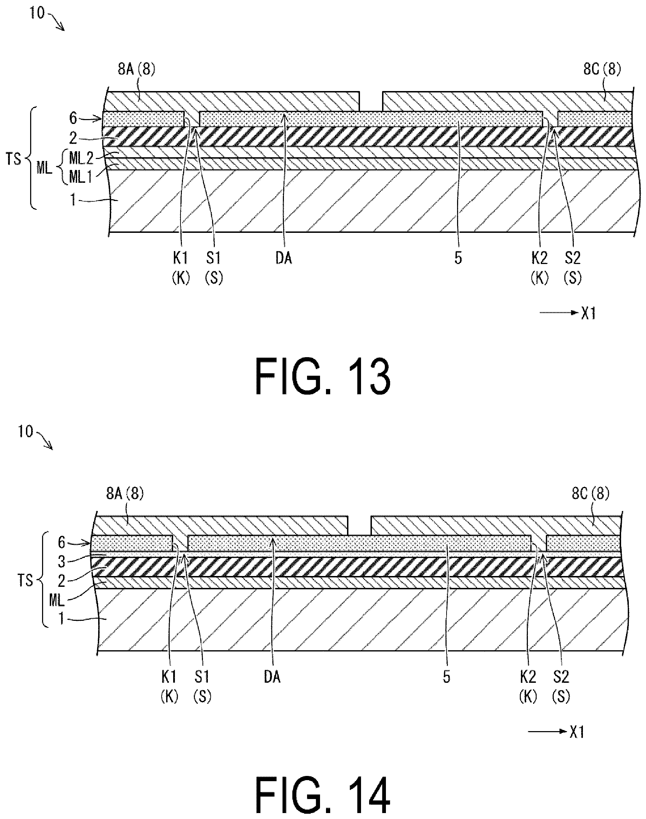

FIG. 13 is a cross-sectional view illustrating another configuration example of the semiconductor substrate 10 in Example 1. As illustrated in FIG. 13, the template substrate TS in the semiconductor substrate 10 may include a plurality of different metal layers as the metal layer ML, and the metal layer ML may be a multi-layer film. The template substrate TS may include, for example, a first metal layer ML1 located on the main substrate 1 and a second metal layer ML2 located on the first metal layer ML1. For example, the first metal layer ML1 may be formed with a material having high affinity with the main substrate 1, and the second metal layer ML2 may be formed with a material having high affinity with the Al-based nitride layer 2. This makes it possible to easily enhance the quality of the Al-based nitride layer 2.

The metal layer ML may include three or more kinds of metal layers. By appropriately switching targets in the sputtering device, a plurality of metal layers can be successively formed.

FIG. 14 is a cross-sectional view illustrating another configuration example of the semiconductor substrate 10 in Example 1. As illustrated in FIG. 14, the template substrate TS in the semiconductor substrate 10 may include a seed portion 3 between the Al-based nitride layer 2 and the mask pattern 6. In this case, the surface of the seed portion 3 exposed in the opening K may be the seed region S. The seed portion 3 may be a seed layer.

The seed portion 3 may be formed at least at part of the opening K (of the mask pattern 6), and may have a plane shape or a pattern shape (e.g., a stripe shape). As the seed portion 3, a GaN layer, an AlN layer, an AlGaN layer, an AlInN layer, AlGaInN, Al, or the like formed at a low temperature (a temperature equal to or lower than 500°C) may be used. The seed portion 3 may be formed with a material different from that of the Al-based nitride layer 2. The seed portion 3 may be formed by the sputtering method, and in this case, the seed portion 3 may contain argon. The argon content in the seed portion 3 may be, for example, not less than 0.01 atm% and not more than 1.0 atm%. The seed portion 3 may be approximately 10 nm to 500 nm in thickness.

For example, when the seed portion 3, which is a GaN layer, is formed by RF sputtering, a gallium nitride target (oxygen content: 0.4 atom%) is used to set the film formation pressure to 0.1 Pa, a nitrogen gas is introduced at 20 to 40 sccm, and the discharge density can be 5 W/cm² and the film-forming temperature can be room temperature. The introduced gas may contain an argon gas.

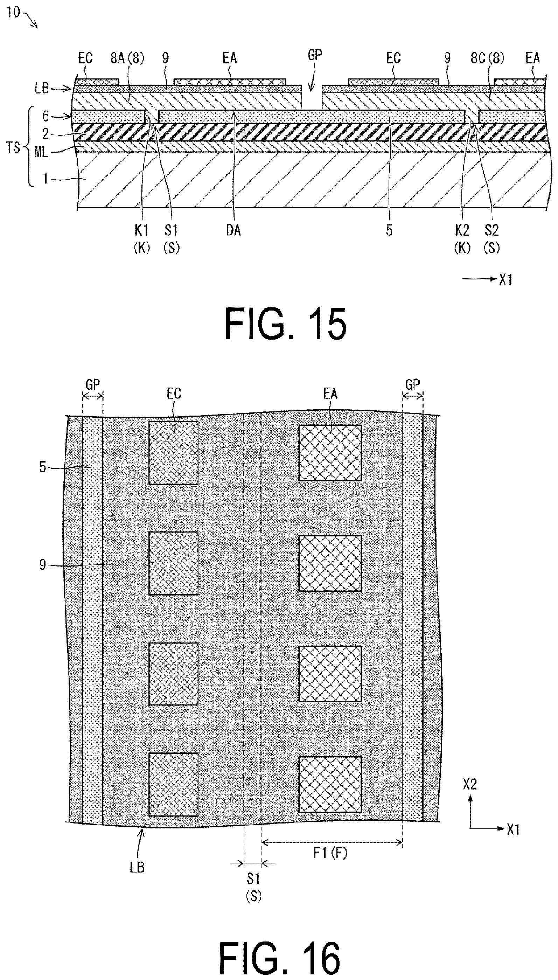

FIG. 15 is a cross-sectional view illustrating another configuration example of the semiconductor substrate in Example 1. FIG. 16 is a plan view illustrating another configuration example of the semiconductor substrate in Example 1. As illustrated in FIG. 15 and FIG. 16, the semiconductor substrate 10 may be provided with an upper layer 9 located above the semiconductor part 8 and including an active layer and a p-type layer.

After the semiconductor part 8 is formed in the MOCVD device, the semiconductor substrate 10 may be taken out from the MOCVD device and stocked in a state where the semiconductor part 8 is exposed. In this case, the stocked semiconductor substrate 10 can be loaded into the MOCVD device to form the upper layer 9. Alternatively, after the semiconductor part 8 is formed in the MOCVD device, the upper layer 9 may be successively formed in the MOCVD device. For example, the upper layer 9 may be formed on the semiconductor part 8 by changing the film formation conditions (e.g., lowering the film-forming temperature by about 100°C) after the growth of the semiconductor part 8 is stopped. The upper layer 9 may include at least one selected from the group consisting of a p-type layer, an n-type layer, and an electron block layer, in addition to the active layer.

The semiconductor substrate 10 may include an anode EA and a cathode EC located on the upper layer 9. The anode EA may be in contact with the p-type layer in the upper layer 9, while the cathode EC may be in contact with the n-type layer in the upper layer 9. Without being limited thereto, the cathode EC may be in contact with the upper surface 8S of the semiconductor part 8. In plan view, at least part of the anode EA may be located to overlap the wing F, or the entire anode EA may be located to overlap the wing F.

A device structure including the semiconductor part 8 and the upper layer 9 is referred to as a laminate body LB. The semiconductor substrate 10 includes a plurality of the laminate bodies LB each having a bar shape. Regarding the upper layer 9 (device layer) formed on the semiconductor part 8, by forming at least an active region (for example, a light emitting region) above the wing F, an element with significantly high quality can be manufactured. In Example 1, the template substrate TS can be formed without using the MOCVD device, and the semiconductor part 8 and the upper layer 9 can be successively formed in the MOCVD device.

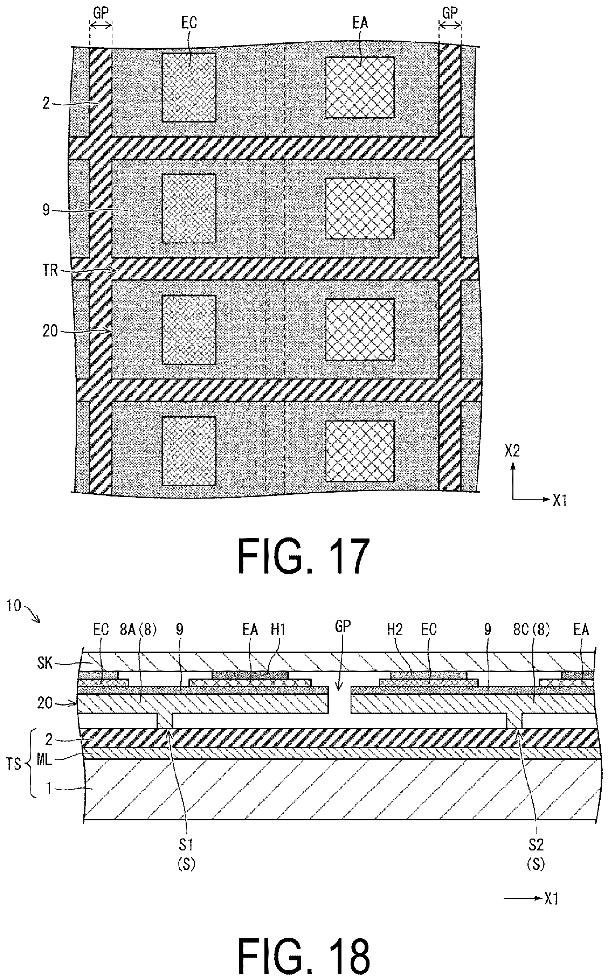

FIG. 17 is a plan view illustrating a method of element isolation in Example 1. FIG. 18 is a cross-sectional view illustrating the method of element isolation in Example 1. As illustrated in FIGs. 17 and 18, the semiconductor substrate 10 may include a plurality of element bodies 20 divided by a plurality of the trenches TR, on the base substrate BS. The element body 20 may include the wing F, the upper layer 9, the anode EA, and the cathode EC.

In the semiconductor substrate 10, the plurality of element bodies 20 may be formed by forming the plurality of trenches TR in the laminate body LB by etching. Further, in the semiconductor substrate 10, the semiconductor part 8 may be divided into the plurality of parts PA (see FIG. 11) by forming the plurality of trenches TR in the semiconductor part 8, and thereafter the upper layer 9, the anode EA, and the cathode EC may be formed on the part PA. Alternatively, in the semiconductor substrate 10, the plurality of element bodies 20 may be formed by cleaving the laminate bodies LB.

In the example illustrated in FIG. 17 and FIG. 18, the mask 5 is removed by etching in which hydrofluoric acid, buffered hydrofluoric acid (BHF), or the like is used. With this, the element bodies 20 can be easily separated from the base substrate BS. For example, the element bodies 20 may be bonded to a support substrate SK via bonding layers H1, H2. Then, the element body 20 can be peeled from the base substrate BS by breaking the bonding between the seed region S and the semiconductor part 8. The support substrate SK may include a conductive pad in contact with the bonding layer H1 and a conductive pad in contact with the bonding layer H2. The bonding layers H1, H2 may each be formed of a solder material.

Specific examples of the element body 20 include a light emitting diode (LED), a semiconductor laser, a Schottky diode, a photodiode, and transistors (including a power transistor and a high electron mobility transistor).

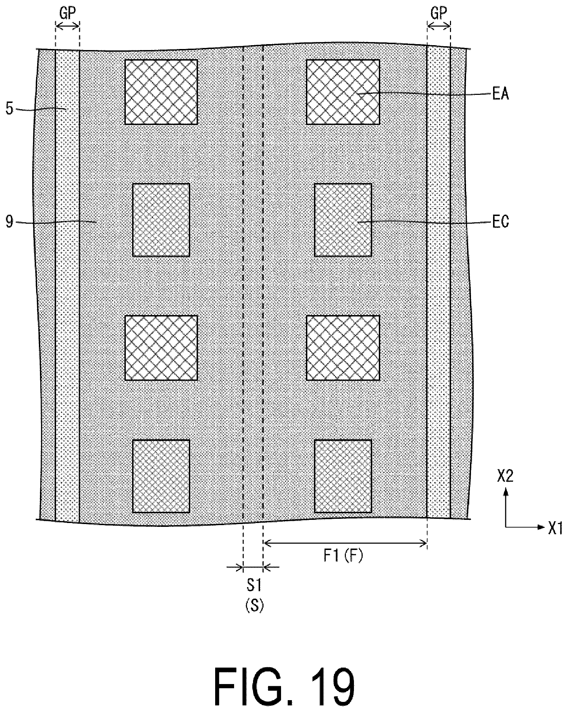

FIG. 19 is a plan view illustrating another configuration example of the semiconductor substrate 10 in Example 1. As illustrated in FIG. 19, the anode EA and the cathode EC may be formed above the same wing F (for example, the first wing F1) in the semiconductor substrate 10. The trench TR may be formed in a portion of the laminate body LB located above the seed region S.

### Example 2

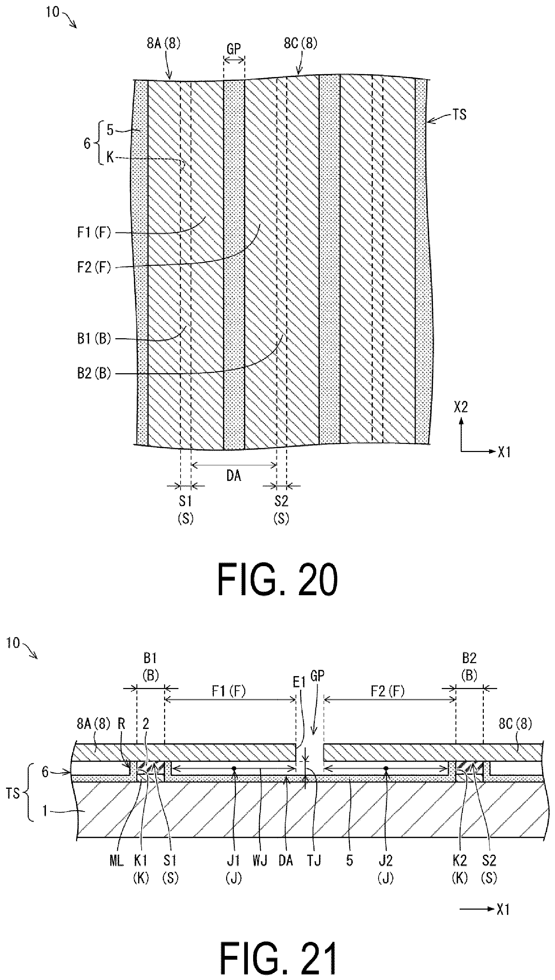

FIG. 20 is a plan view schematically illustrating a configuration of a semiconductor substrate 10 in Example 2. FIG. 21 is a cross-sectional view schematically illustrating the configuration of the semiconductor substrate 10 in Example 2. In FIG. 21, black dots depicted at positions indicated by leader lines of reference signs J1 and J2 refer to spaces (vacant spaces) between wings F and a template substrate TS.

As illustrated in FIGs. 20 and 21, in the semiconductor substrate 10 in Example 2, the template substrate TS may include a ridge R on the upper surface side, and a first seed region S1 may be located on an upper surface of the ridge R. A first vacant space J1 may exist between a first semiconductor part 8A and a mask 5. The first vacant space J1 can also be referred to as a space between a growth suppression region DA and a first wing F1. The first wing F1 is separated from the mask 5, which functions as the growth suppression region DA. Note that (the surface of) the first seed region S1 is located above the growth suppression region DA; the first semiconductor part 8A includes a first base B1 located on the first seed region S1, and the first wing F1 contact to the first base B1 and facing the growth suppression region DA with the first vacant space J1 interposed between the growth suppression region DA and the first wing F1.

In the template substrate TS, an Al-based nitride layer 2 need not overlap the mask 5 in plan view. In the template substrate TS, at least part of a metal layer ML may be included in the ridge R. In the template substrate TS of Example 2, the metal layer ML and the Al-based nitride layer 2 may be included in the ridge R.

The upper surface (first seed region S1) of the ridge R may be constituted of the Al-based nitride layer 2, and a side surface of the ridge R may be covered with the mask 5. In the template substrate TS, the side surface of the ridge R may include part of the mask 5. The metal layer ML and the Al-based nitride layer 2 need not be exposed at the side surface of the ridge R. The side surface of the ridge R does not need to be in contact with the first wing F1. The entire side surface of the ridge R may face the first vacant space J1. This reduces a contact area between the ridge R and the first wing F1, thereby making it possible to reduce the defect density of the first wing F1.

The first semiconductor part 8A can be formed by an epitaxial lateral overgrowth (ELO) method while taking the Al-based nitride layer 2 exposed at a lower side of a first opening K1 as a starting point. The Al-based nitride layer 2 may be a seed layer including the first seed region S1. A second semiconductor part 8C grows in the lateral direction on the mask 5 while taking the Al-based nitride layer 2 exposed at a lower side of a second opening K2 as a starting point. The growth may be stopped before the first semiconductor part 8A and the second semiconductor part 8C meet each other. In this case, an edge E1 of the first wing F1 can be formed above the growth suppression region DA.

The aspect ratio of the first vacant space J1 (the ratio of a width WJ in the first direction X1 to a thicknesses TJ) can be set to 5.0 or more. In this case, the wide first wing F1 having high crystallinity (low defect density) can be rapidly formed. In addition, the flatness of the first wing F1 is improved. The width WJ of the first vacant space J1 is a distance in the first direction X1 from the side surface of the ridge R to an edge E of the first semiconductor part 8A. The thickness (height) TJ of the first vacant space is a distance from the upper surface of the mask 5 forming the growth suppression region DA to the lower surface (back surface) of the first semiconductor part 8A.

The first wing F1 may be such that the ratio of the width in the first direction X1 to the thickness is 2.0 or more. The width of the first wing F1 in the first direction X1 may be equal to or larger than 7.0 µm; for example, it may be equal to or larger than 10.0 µm, equal to or larger than 20.0 µm, or equal to or larger than 40.0 µm. The width of the first wing F1 in the first direction X1 is preferably equal to or smaller than 80.0 µm. This can lower the possibility that the semiconductor part 8 is warped in a direction toward the substrate due to the gravity. The thickness of the first wing F1 in the first direction X1 may be, for example, equal to or smaller than 10.0 µm, equal to or smaller than 5.0 µm, or equal to or smaller than 2.0 µm. As illustrated in FIG. 21, the width of a gap GP may be larger than the thickness TJ of the first vacant space J1.

In the semiconductor substrate 10, a second vacant space J2 may exist between the second semiconductor part 8C and the mask 5, and the second vacant space J2 may have the same constitution as the first vacant space J1. Therefore, repeated description regarding the second vacant space J2 is omitted.

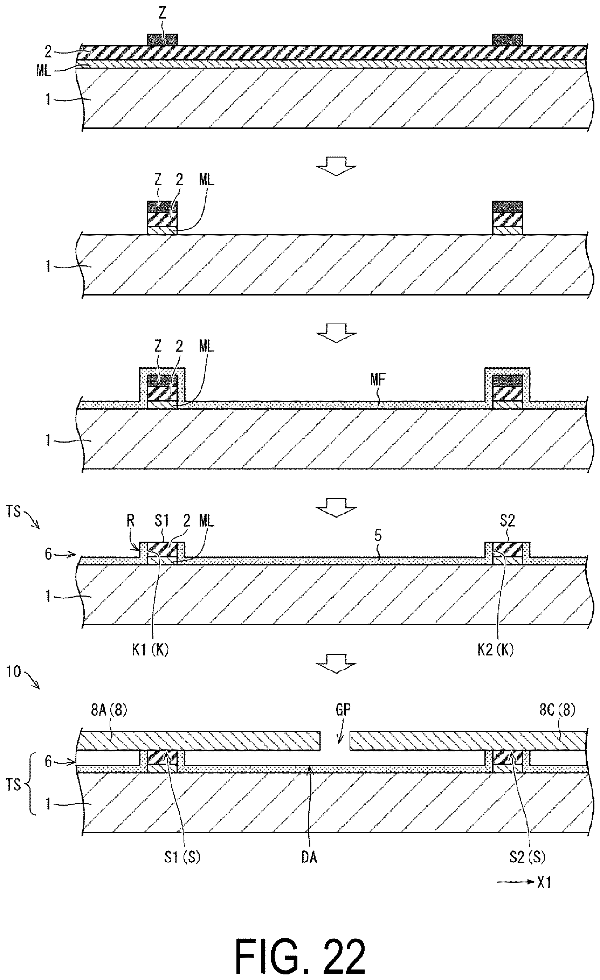

FIG. 22 is a cross-sectional view illustrating an example of a manufacturing method of the semiconductor substrate 10 in Example 2. The semiconductor substrate 10 of Example 2 can be manufactured as follows. A silicon substrate (Si (111) plane) is used as the main substrate 1, an Al film as the metal layer ML is formed on the silicon substrate, and then an AlN film as the Al-based nitride layer 2 is formed on the Al film. The sputtering method is used for film formation of the metal layer ML and the Al-based nitride layer 2.

Subsequently, a resist Z having a stripe shape and having a width of about 3 µm is formed on the upper portion of the Al-based nitride layer 2 by using the photolithography technique, and the ridge R is formed by using a dry etching process. At this time, the Al-based nitride layer 2 and the metal layer ML are partially etched. In this case, the resist Z is not removed, and a mask layer MF (e.g., a SiN film having a thickness of 10 nm) to become the mask 5 is formed on the main substrate 1 and the resist Z.

When the semiconductor part 8 is in contact with the mask 5 on the growth suppression region DA as in Example 1 discussed above, the mask 5 needs to be at least approximately 100 nm in thickness. Then, when the semiconductor part 8 comes into contact with the mask 5 and interferes with the ELO growth, the surface flatness of the semiconductor part 8 may be affected in some cases. On the other hand, in Example 2, since the wing F floats in the air, the wing F and the mask 5 are not brought into contact with each other above the growth suppression region DA. Therefore, even when the mask 5 is made considerably thin, the growth of the wing F is not obstructed, and the internal stress of the semiconductor part 8 can be reduced. As a result, the warp of the semiconductor substrate 10 can be reduced with ease.

Thinning the mask 5 improves the flatness of the back surface of the wing F. The mask 5 may have a thickness being equal to or smaller than 1 µm, or equal to or smaller than 50 nm. Setting the thickness of the mask 5 to be equal to or less than 50 nm improves the flatness. The thickness thereof can be set to be equal to or less than 30 nm.

Then, the resist Z is removed and the mask layer MF on the ridge R is lifted off. After that, the first opening K1 is formed, thereby forming the template substrate TS (selective growth substrate). Manufacturing the template substrate TS without using the MOCVD method achieves a significant cost reduction, and an industrial advantage is very large.

Subsequently, the template substrate TS is put in the MOCVD device, and the semiconductor part 8 is formed on the template substrate TS by the ELO method. In Example 2, the semiconductor part 8 was a GaN layer, a growth temperature was 1000 to 1200 degrees, a V/III ratio was 500 to 20000, and a growth pressure was 50 kPa. In order to make the semiconductor part 8 be an n-type, doping with Si may be performed as in Example 1 discussed above. The film formation conditions are preferably set in at least two stages. In the first stage, the film-forming temperature is set to about 1030°C, V/III is set to about 2000, and a growth nucleus (longitudinal growth portion) of the ELO layer (semiconductor part 8) is formed on the opening K. The thickness (height) of the growth nucleus may be about 0.2 µm to 3 µm, and the width thereof may be about the same as the width of the ridge R or may have a size slightly protruding in the a-axis direction (<11-20> direction). In the second stage, the film-forming temperature was raised by about 100°C to grow the GaN layer in the lateral direction (a-axis direction) from the growth nucleus, and the growth was stopped when the width of the gap GP between the semiconductor parts 8 (GaN layers) growing over the vacant space in the directions opposite to each other reached a specified value (equal to or less than 10 µm). The semiconductor substrate 10 obtained as described above (where the semiconductor part 8 is exposed) may be taken out from the MOCVD device and stocked; alternatively, an upper layer including an active layer and the like may be successively formed in the MOCVD device.

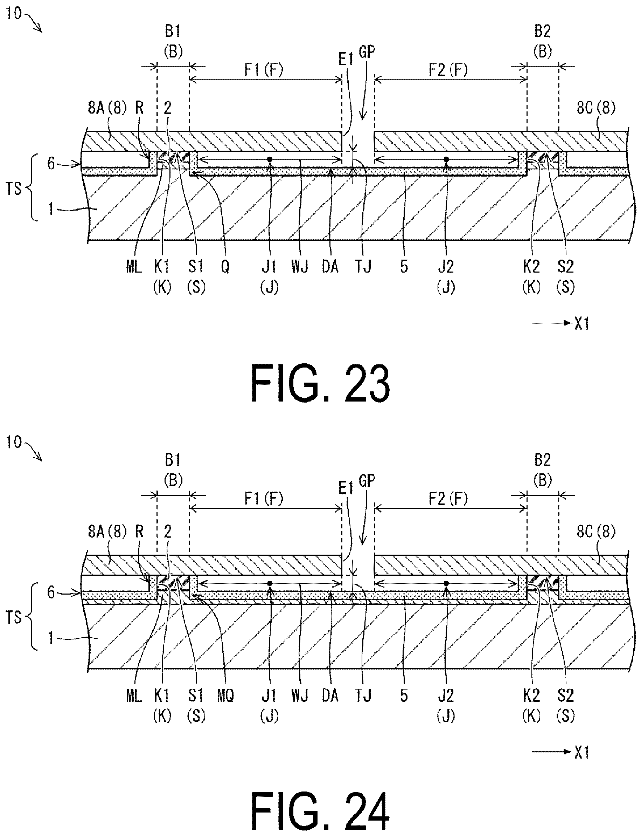

FIG. 23 is a cross-sectional view illustrating another configuration example of the semiconductor substrate 10 in Example 2. As illustrated in FIG. 23, in the semiconductor substrate 10, the main substrate 1 may include a protruding portion Q on a main surface 1a, and at least part of the protruding portion Q may be included in the ridge R. The metal layer ML and the Al-based nitride layer 2 may be located on the protruding portion Q. When the ridge R is formed by a dry etching process, the protruding portion Q can be formed by removing part of the main substrate 1. In the example illustrated in FIG. 23, since the first vacant space J1 can be more reliably formed, the warp of the semiconductor substrate 10 can be easily reduced.

FIG. 24 is a cross-sectional view illustrating another configuration example of the semiconductor substrate 10 in Example 2. As illustrated in FIG. 24, in the semiconductor substrate 10, the metal layer ML may include a protruding portion MQ on a face on the Al-based nitride layer 2 side, and the Al-based nitride layer 2 may be located on the protruding portion MQ. At least part of the metal layer ML may be located between the main substrate 1 and the mask 5. When the ridge R is formed by the dry etching process, part of the metal layer ML on the main substrate 1 is not removed but remains, whereby the protruding portion MQ can be formed.

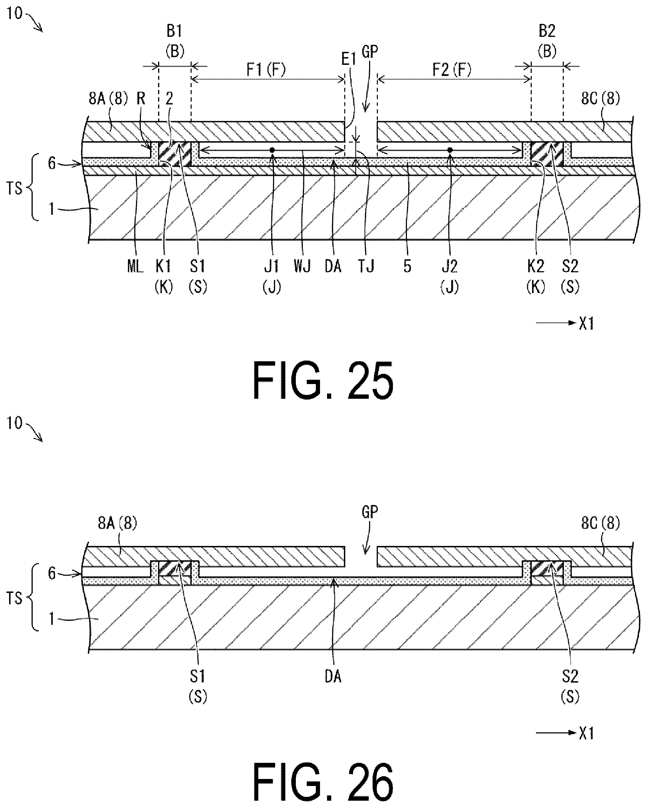

FIG. 25 is a cross-sectional view illustrating another configuration example of the semiconductor substrate 10 in Example 2. As illustrated in FIG. 25, in the semiconductor substrate 10, the metal layer ML may be located on the entire surface of the main substrate 1, and the Al-based nitride layer 2 may be locally located on the metal layer ML. In the example illustrated in FIG. 25, the metal layer ML need not be included in the ridge R.

FIG. 26 is a cross-sectional view illustrating another configuration example of the semiconductor substrate 10 in Example 2. As illustrated in FIG. 26, in the semiconductor substrate 10, the side surface (the mask 5) of the ridge R may be in contact with the first wing F1. As long as the first wing F1 is not in contact with the mask 5 of the growth suppression region DA, the first vacant space J1 can be formed. Therefore, no problem arises.

### Example 3

Although the Al-based nitride layer 2 is formed on the main substrate 1 in Example 1 and Example 2 discussed above, the present disclosure is not limited thereto; the Al-based nitride layer 2 may be formed on a substrate different from the main substrate 1 (hereinafter referred to as a temporary substrate 1T), and then the Al-based nitride layer 2 may be transferred to the main substrate 1.

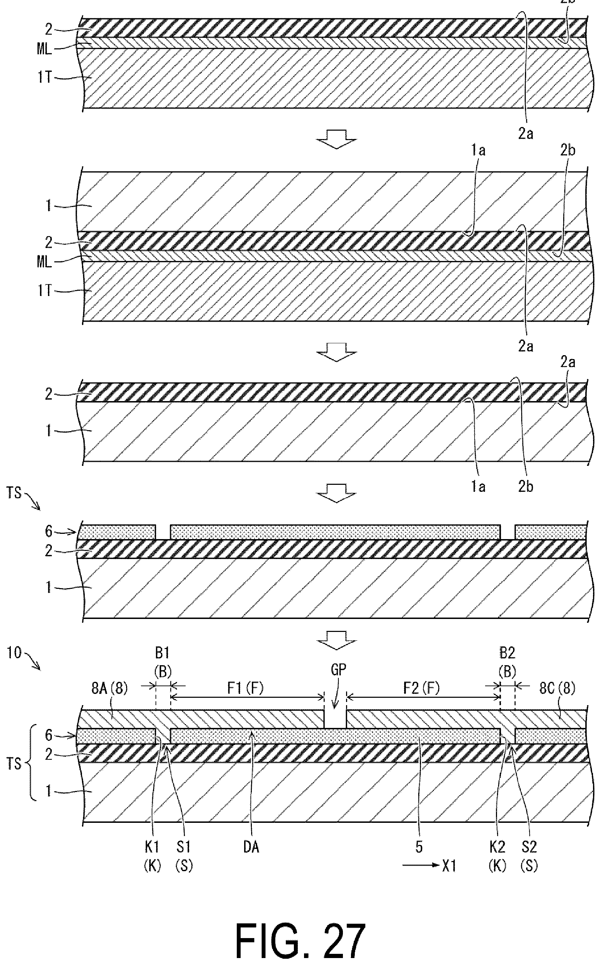

FIG. 27 is a cross-sectional view illustrating an example of a manufacturing method of a semiconductor substrate 10 in Example 3. As illustrated in FIG. 27, first, a metal layer ML and the Al-based nitride layer 2 are formed above the temporary substrate 1T by the sputtering method. The material of the temporary substrate 1T is not particularly limited as long as it is a material on which the metal layer ML and the Al-based nitride layer 2 can be formed. Since the temporary substrate 1T can be reused as described later, even when a relatively expensive substrate is used, the influence on the manufacturing cost is small. As the temporary substrate 1T, for example, a 4H-SiC substrate can be used. A silicon substrate can be used as the main substrate 1.

The metal layer ML may be formed on the entire surface of the temporary substrate 1T, and the Al-based nitride layer 2 may be formed on the metal layer ML. In general, an AlN film is formed on the 4H-SiC substrate by the sputtering method in some cases. As in the example illustrated in FIG. 27, by forming the Al-based nitride layer 2 on the temporary substrate 1T with the metal layer ML interposed therebetween, the Al-based nitride layer 2 with quality higher than that of the known Al-based nitride layer can be formed.

Subsequently, for example, a first surface 2a of the Al-based nitride layer 2 and a main surface 1a of the main substrate 1 are respectively subjected to plasma treatment in a vacuum to clean the surfaces. As a result, the surfaces can be activated (dangling bonds are present on the surfaces). Thereafter, by bringing the first surface 2a of the Al-based nitride layer 2 into contact with the main surface 1a of the main substrate 1, the Al-based nitride layer 2 and the main substrate 1 can be bonded to each other by surface activated bonding.

Thereafter, by removing the metal layer ML to separate the temporary substrate 1T, the Al-based nitride layer 2 can be transferred to the main substrate 1. The subsequent processing may be the same as or similar to that of Example 1; a mask pattern 6 is formed on the Al-based nitride layer 2, and a semiconductor part 8 can be formed using the ELO method.

In Example 3, even when the metal layer ML is formed to be relatively thick, no problem arises because the metal layer ML is removed at the time of transfer. Therefore, the quality of the Al-based nitride layer 2 can be easily enhanced. The temporary substrate 1T can be repeatedly used by removing the metal layer ML on the surface thereof.

As described above, in Example 3, for example, the high-quality Al-based nitride layer 2 formed on the 4H-SiC substrate can be transferred onto the silicon substrate as the main substrate 1. This makes it possible to form a template substrate TS including the Al-based nitride layer 2 with quality higher than that of the known Al-based nitride layer, on the silicon substrate. The semiconductor substrate 10 can be manufactured using such template substrate TS. Accordingly, characteristics of various devices can be improved by using the semiconductor substrate 10.

In Example 3, since the Al-based nitride layer 2 need not epitaxially grow on the main surface 1a, the main substrate 1 may be, for example, a silicon substrate, and the plane orientation of the main surface 1a may be a (100) plane. In general, since an electronic circuit or the like can be formed on the Si (100) plane, for example, using a silicon substrate (Si (100) plane) as the main substrate 1 makes it possible to integrate a light-emitting element and an electronic circuit in a semiconductor device formed by using the semiconductor substrate 10.

The first surface 2a of the Al-based nitride layer 2 facing the main surface 1a of the main substrate 1 may be, for example, an N polar plane, and in this case, a second surface 2b of the Al-based nitride layer 2 may be an Al polar plane. When the plane orientation of the main surface 1a of the main substrate 1 is the (100) plane, since the first surface 2a of the Al-based nitride layer 2 has a hexagonal crystal structure, the main surface 1a and the first surface 2a have different crystal atomic arrangement patterns in the in-plane direction.

When the plane orientation of the main surface 1a of the main substrate 1 is the (111) plane, the x-axis and y-axis directions of the unit lattice in the atomic arrangement of the main surface 1a may be different from the x-axis and y-axis directions of the unit lattice in the atomic arrangement of the first surface 2a of the Al-based nitride layer 2. Due to the presence of a bonding trace which is a difference between the main surface 1a and the first surface 2a, the AlN film epitaxially grown on the main substrate 1 and the Al-based nitride layer 2 transferred onto the main substrate 1 can be distinguished from each other. The bonding trace can be confirmed based on, for example, a result of X-ray measurement or the like.

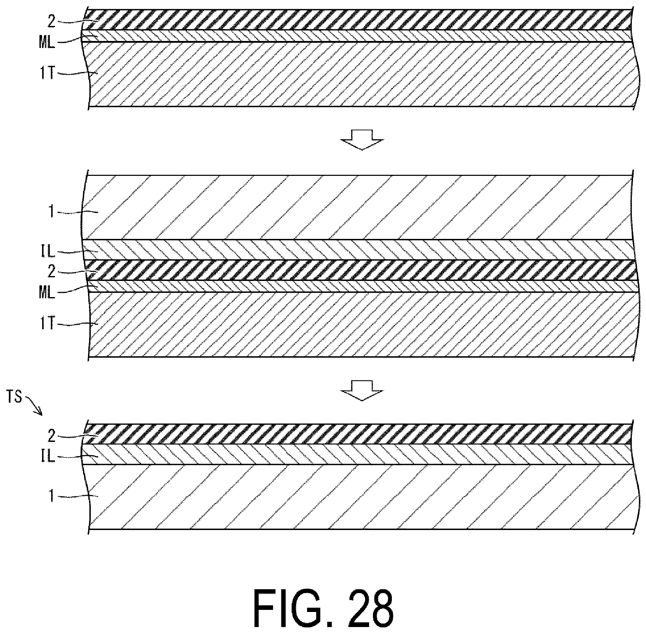

FIG. 28 is a cross-sectional view illustrating an example of a manufacturing method of the template substrate TS of another configuration example in Example 3. As illustrated in FIG. 28, an Al film (thickness: 100 nm) is formed as the metal layer ML by using a 4H-SiC substrate as the temporary substrate 1T. Then, the Al-based nitride layer 2 is formed on the Al film. The Al-based nitride layer 2 may be a ScAlN film (thickness: 1000 nm).

A silicon substrate is used as the main substrate 1, and an intermediate layer IL is formed on the main substrate 1. The intermediate layer IL may be, for example, a molybdenum film (thickness: 1000 nm) and can be formed by the sputtering method. The surface of the intermediate layer IL is cleaned, and the intermediate layer IL and the Al-based nitride layer 2 are activated and bonded. By removing the metal layer ML, the Al-based nitride layer 2 is transferred onto the intermediate layer IL of the main substrate 1.

Thus, the template substrate TS including the main substrate 1, the intermediate layer IL on the main substrate 1, and the Al-based nitride layer 2 on the intermediate layer IL can be manufactured. Such template substrate TS can be used for manufacturing, for example, a BAW filter in which the Al-based nitride layer 2 is used as a piezoelectric layer and the intermediate layer IL is used as an elastic wave reflector.

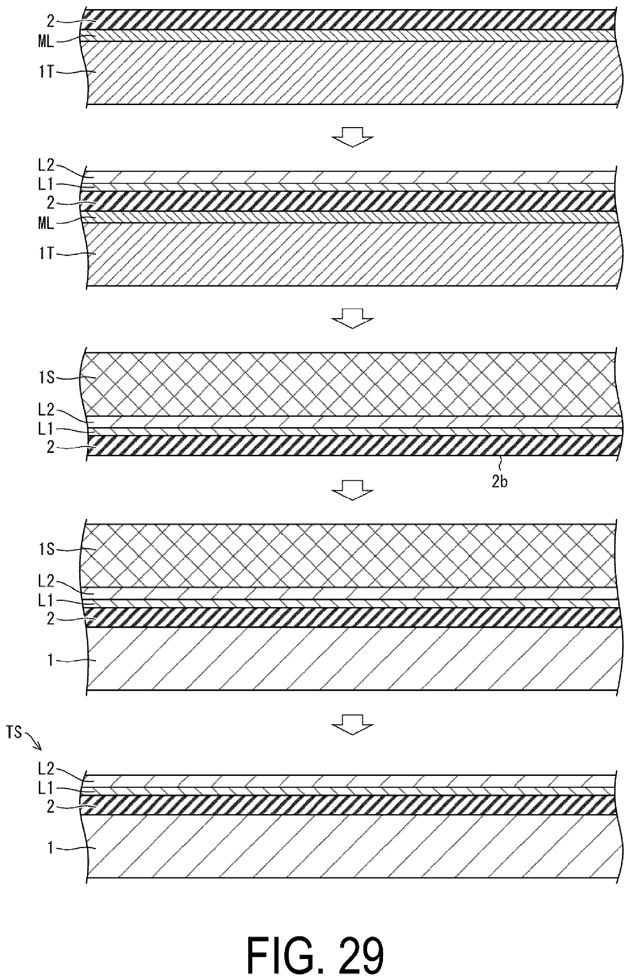

FIG. 29 is a cross-sectional view illustrating an example of a manufacturing method of the template substrate TS of another configuration example in Example 3. As illustrated in FIG. 29, an Al film (thickness: 100 nm) is formed as the metal layer ML by using a 4H-SiC substrate as the temporary substrate 1T. Then, an AlN film (thickness: 200 nm) as the Al-based nitride layer 2 is formed on the Al film. Further, a GaN film (thickness: 1000 nm) is formed as a first layer L1 on the Al-based nitride layer 2, and an AlGaN film (thickness: 10 nm) is formed as a second layer L2 on the first layer L1. Each of the metal layer ML, the Al-based nitride layer 2, the first layer L1, and the second layer L2 is formed by the sputtering method.

Subsequently, the second layer L2 is temporarily bonded to a support substrate 1S. The material of the support substrate 1S is not particularly limited, and a known method can be appropriately used for a technique of temporary bonding. By removing the metal layer ML, the Al-based nitride layer 2, the first layer L1, and the second layer L2 are transferred onto the support substrate 1S.

Thereafter, for example, the second surface 2b of the Al-based nitride layer 2 and the main surface 1a of the main substrate 1 are each subjected to plasma treatment in a vacuum, and the second surface 2b and the main surface 1a are brought into contact with each other, whereby the Al-based nitride layer 2 and the main substrate 1 are bonded to each other by surface activated bonding. Subsequently, by removing the temporary bonding between the second layer L2 and the support substrate 1S, the Al-based nitride layer 2, the first layer L1, and the second layer L2 can be transferred to the main substrate 1.

Thus, the template substrate TS can be manufactured including the main substrate 1, the Al-based nitride layer 2 on the main substrate 1, the first layer L1 on the Al-based nitride layer 2, and the second layer L2 on the first layer L1. Such template substrate TS can be used for manufacturing, for example, an HEMT in which the first layer L1 serves as an electron-passing layer and the second layer L2 serves as an electron-generating layer.

### Example 4

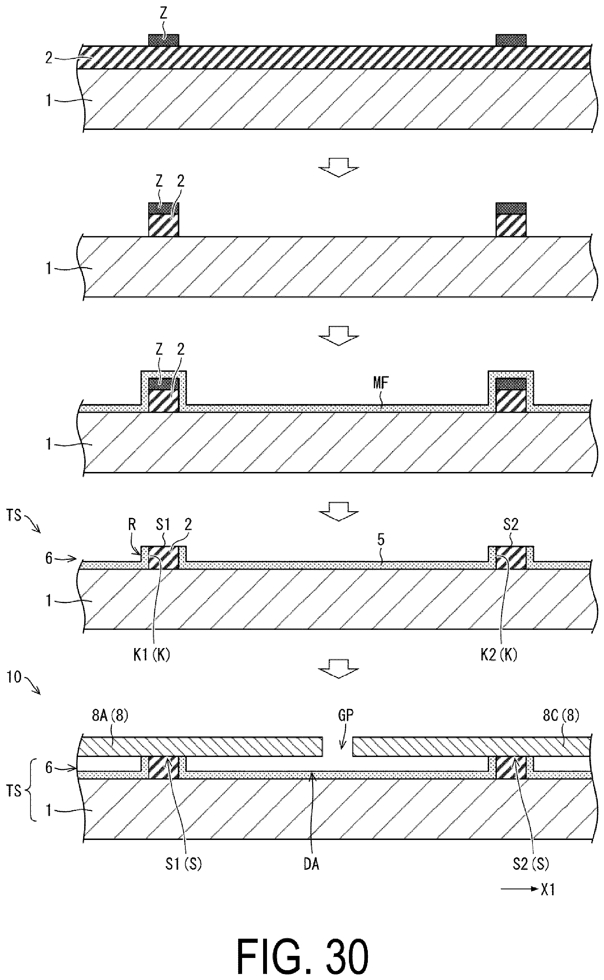

FIG. 30 is a cross-sectional view illustrating an example of a manufacturing method of a semiconductor substrate 10 in Example 4. As illustrated in FIG. 30, the semiconductor substrate 10 can have a structure (ridge structure) including a ridge R as in Example 2 by using the template substrate TS of Example 3 described above.

First, by using the template substrate TS including the main substrate 1 and the Al-based nitride layer 2 located on the main substrate 1, a stripe-shaped resist Z is formed on the Al-based nitride layer 2. Part of the Al-based nitride layer 2 is etched by a dry etching process. A mask layer MF (e.g., a SiN film having a thickness of 10 nm) to become a mask 5 is formed on the main substrate 1 and the resist Z.

Thereafter, the template substrate TS and the semiconductor substrate 10 can be manufactured by carrying out the same processing as the processing described in Example 2. The template substrate TS includes, on its upper surface side, the ridge R, where a first seed region S1 is located. In the semiconductor substrate 10, a first vacant space J1 exists between a first semiconductor part 8A and a growth suppression region DA.

In the template substrate TS, the growth suppression region DA may be a reformed region of the Al-based nitride layer 2, and the first seed region S1 may be a non-reformed region of the Al-based nitride layer 2. The Al-based nitride layer 2 can be reformed by performing, for example, plasma treatment on the Al-based nitride layer 2.

In the plasma treatment, for example, a predetermined region of the Al-based nitride layer 2 is irradiated with argon plasma to reform the surface of the irradiated region, thereby forming the growth suppression region DA. By introducing not only an argon gas but also an oxygen gas, nitrogen gas, hydrogen gas, or the like into the chamber, oxygen plasma, nitrogen plasma, hydrogen plasma, or mixed plasma thereof can be used for the plasma treatment in addition to argon plasma. Thus, the growth suppression region DA may contain argon, oxygen, nitrogen, or the like as an impurity. In such a case, the Al-based nitride layer 2 may be aluminum nitride, and the growth suppression region DA may be aluminum oxynitride. The Al-based nitride layer 2 may be aluminum scandium nitride (AlScN), and the growth suppression region DA may be aluminum scandium oxynitride (AlScON).

### Supplementary Notes

The invention according to the present disclosure has been described above based on the drawings and examples. However, the invention according to the present disclosure is not limited to the above-described embodiments and examples. That is, the invention according to the present disclosure can be variously changed within the scope illustrated in the present disclosure, and embodiments obtained by appropriately combining the technical means disclosed in different embodiments and examples are also included in the technical scope of the invention according to the present disclosure. In other words, note that a person skilled in the art can easily make different variations or modifications based on the present disclosure. Note that these variations or modifications are included within the scope of the present disclosure.

### REFERENCE SIGNS

1 Main substrate
2 Al-based nitride layer
5 Mask
6 Mask pattern
8 Semiconductor part
8A First semiconductor part
8C Second semiconductor part
10 Semiconductor substrate
B Base
DA Growth suppression region
F Wing
GP Gap
K Opening
ML Metal layer
S Seed region
TS Template substrate

## Claims

1. A semiconductor substrate comprising:
a template substrate comprising a first seed region and a growth suppression region; and
a first semiconductor part comprising
a first base located above the first seed region, and
a first wing contact to the first base and located above the growth suppression region, wherein
the template substrate comprises a main substrate, a metal layer located above the main substrate, and an aluminum-based nitride layer located above the metal layer and containing argon, and
the first semiconductor part comprises a nitride semiconductor.

2. The semiconductor substrate according to claim 1, wherein
the aluminum-based nitride layer is an aluminum nitride layer,
the main substrate is a heterogeneous substrate having a lattice constant different from a lattice constant of the first semiconductor part,
the aluminum nitride layer is a seed layer comprising the first seed region and is in contact with the first base, and
the first semiconductor part does not contain argon.

3. The semiconductor substrate according to claim 1 or 2, wherein
the metal layer contains argon and/or hydrogen.

4. The semiconductor substrate according to any one of claims 1 to 3, wherein
the metal layer contains one or more metals selected from the group consisting of aluminum, platinum, palladium, silver, gold, hafnium, scandium, yttrium, titanium, and zirconium.

5. The semiconductor substrate according to any one of claims 1 to 3, wherein
the metal layer contains at least one metal in which a (111) plane of a face-centered cubic lattice or a body-centered cubic lattice, or a (0001) plane of a hexagonal close-packed lattice is oriented to a main surface of the main substrate.

6. The semiconductor substrate according to any one of claims 1 to 5, wherein
the metal layer comprises a first layer made of a metal material and a second layer made of a metal material different from the metal material of the first layer.

7. The semiconductor substrate according to any one of claims 1 to 6, wherein
the metal layer overlaps an entire upper surface of the main substrate in plan view as seen along a normal direction of the main substrate.

8. The semiconductor substrate according to any one of claims 1 to 7, further comprising:
a metal nitride layer located between the metal layer and the aluminum-based nitride layer.

9. The semiconductor substrate according to any one of claims 1 to 8, wherein
a thickness of the metal layer is equal to or greater than 20 nm.

10. The semiconductor substrate according to any one of claims 1 to 9, wherein
a thermal expansion coefficient at 1000°C of the aluminum-based nitride layer is larger than a thermal expansion coefficient at 1000°C of the main substrate and smaller than a thermal expansion coefficient at 1000°C of the first semiconductor part.

11. The semiconductor substrate according to any one of claims 1 to 10, wherein
at ambient temperature, the aluminum-based nitride layer is in a compressive stress state and the first semiconductor part is in a tensile stress state.

12. The semiconductor substrate according to any one of claims 1 to 11, wherein
the template substrate comprises a mask pattern comprising
a mask serving as the growth suppression region, and
an opening corresponding to the first seed region.

13. The semiconductor substrate according to claim 12, wherein
the aluminum-based nitride layer overlaps the mask.

14. The semiconductor substrate according to claim 12, wherein
the aluminum-based nitride layer does not overlap the mask.

15. The semiconductor substrate according to claim 12, wherein
the template substrate comprises, on an upper surface side, a ridge where the first seed region is located, and
a vacant space is present between the first semiconductor part and the mask.

16. The semiconductor substrate according to claim 15, wherein
the ridge comprises at least part of the metal layer.

17. The semiconductor substrate according to claim 15 or 16, wherein
the main substrate comprises a protruding portion on an upper surface side, and
the ridge comprises at least part of the protruding portion.

18. The semiconductor substrate according to any one of claims 15 to 17, wherein
a side surface of the ridge comprises part of the mask.

19. A semiconductor substrate comprising:
a template substrate comprising a first seed region and a growth suppression region; and
a first semiconductor part comprising
a first base located above the first seed region, and
a first wing contact to the first base and located above the growth suppression region, wherein
the template substrate comprises a main substrate, and an aluminum-based nitride layer in which a nitrogen polar plane is bonded to the main substrate and containing argon, and
the first semiconductor part comprises a nitride semiconductor.

20. The semiconductor substrate according to claim 19, wherein
the aluminum-based nitride layer does not inherit a crystal structure of the main substrate at an interface with the main substrate.

21. The semiconductor substrate according to claim 19 or 20, further comprising:
a bonding trace at the interface between the aluminum-based nitride layer and the main substrate.

22. The semiconductor substrate according to any one of claims 19 to 21, wherein
the template substrate comprises, on an upper surface side, a ridge where the first seed region is located, and
a vacant space is present between the first semiconductor part and the growth suppression region.

23. The semiconductor substrate according to any one of claims 1 to 22, wherein
each of the first seed region and the growth suppression region arranged side by side in a first direction has a shape whose longitudinal direction is a second direction orthogonal to the first direction.

24. The semiconductor substrate according to any one of claims 1 to 23, further comprising:
a second semiconductor part comprising a nitride semiconductor, wherein
the template substrate comprises a second seed region adjacent to the first seed region in the first direction with the growth suppression region interposed between the first seed region and the second seed region,
the second semiconductor part comprises a second base located above the second seed region, and a second wing contact to the second base and located above the growth suppression region, and
the first wing and the second wing are arranged side by side in the first direction with a gap interposed between the first wing and the second wing.

25. The semiconductor substrate according to any one of claims 1 to 24, wherein
the nitride semiconductor is a GaN-based semiconductor, and
the main substrate is a silicon substrate or a silicon carbide substrate, or a glass substrate.

26. The semiconductor substrate according to any one of claims 1 to 10, wherein
at ambient temperature, each of the aluminum-based nitride layer and the first semiconductor part is in a tensile stress state.

27. The semiconductor substrate according to any one of claims 1 to 11, wherein
the growth suppression region is a reformed region of the aluminum-based nitride layer, and
the first seed region is a non-reformed region of the aluminum-based nitride layer.

28. The semiconductor substrate according to claim 2, wherein
a ratio of impurity metal elements other than aluminum to all the metal elements in the aluminum nitride layer is less than 0.5 atm%.

29. A template substrate comprising:
a main substrate;
a metal layer located above the main substrate; and
an aluminum-based nitride layer located above the metal layer and containing argon.

30. A manufacturing method of a template substrate comprising a main substrate, the manufacturing method comprising the steps of:
forming a metal layer above the main substrate; and
forming an aluminum-based nitride layer above the metal layer by using a sputtering method.

31. A manufacturing method of a template substrate comprising a main substrate, the manufacturing method comprising the steps of:
forming a metal layer on a temporary substrate;
forming an aluminum-based nitride layer above the metal layer by using a sputtering method; and
transferring the aluminum-based nitride layer from the temporary substrate to the main substrate.

32. The manufacturing method of a template substrate according to claim 31, wherein
a surface of the aluminum-based nitride layer is a nitrogen polar plane when the aluminum-based nitride layer is formed by the sputtering method, and the surface of the aluminum-based nitride layer is an Al polar plane after the transferring.

33. The manufacturing method of a template substrate according to claim 31 or 32, wherein
the main substrate and the aluminum-based nitride layer are isolated from the temporary substrate by removing the metal layer.

34. The manufacturing method of a template substrate according to any one of claims 31 to 33, wherein
the temporary substrate is a silicon carbide substrate, and the main substrate is a silicon substrate.

35. The manufacturing method of a template substrate according to any one of claims 30 to 34, wherein
the metal layer is an aluminum layer, and
the aluminum layer is formed by using the sputtering method.

36. The manufacturing method of a template substrate according to claim 30, wherein
a mask pattern comprising a mask serving as a growth suppression region is formed above the main substrate.

37. A manufacturing apparatus of a template substrate, the manufacturing apparatus being configured to perform each of the steps according to claim 30 or 31.
